(19) **Europäisches Patentamt / European Patent Office / Office européen des brevets**

(11) **EP 4 312 029 B1**

(12) **EUROPEAN PATENT SPECIFICATION**

(45) Date of publication and mention
of the grant of the patent:
**01.04.2026  Bulletin 2026/14**

(21) Application number: **23183862.4**

(22) Date of filing: **06.07.2023**

(51) International Patent Classification (IPC):
**G01R 1/00** *(2006.01)*          **G01R 1/20** *(2006.01)*
**G01L 1/20** *(2006.01)*          **G01K 7/24** *(2006.01)*
**G01K 1/02** *(2021.01)*          G01F 23/28 *(2006.01)*
**G01L 1/00** *(2006.01)*          G01K 1/00 *(2006.01)*

(52) Cooperative Patent Classification (CPC):
**G01K 1/026; G01K 7/24; G01L 1/205; G01R 1/203;**
G01F 23/28; G01K 2213/00

(54) **ELEMENT ARRAY CIRCUIT, ELECTROMAGNETIC WAVE SENSOR, TEMPERATURE SENSOR, AND STRAIN SENSOR**

ELEMENTARRAYSCHALTUNG, ELEKTROMAGNETISCHER WELLENSENSOR, TEMPERATURSENSOR UND DEHNUNGSSENSOR

CIRCUIT DE RÉSEAU D'ÉLÉMENTS, CAPTEUR D'ONDES ÉLECTROMAGNÉTIQUES, CAPTEUR DE TEMPÉRATURE ET CAPTEUR DE CONTRAINTE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority:  **29.07.2022   JP 2022121176**

(43) Date of publication of application:
**31.01.2024   Bulletin 2024/05**

(73) Proprietor: **TDK Corporation**
**Tokyo 103-6128 (JP)**

(72) Inventors:
• **SENRIUCHI, Tadao**
**Tokyo, 103-6128 (JP)**
• **OHTA, Naoki**
**Tokyo, 103-6128 (JP)**
• **MAEKAWA, Kazuya**
**Tokyo, 103-6128 (JP)**
• **AOKI, Susumu**
**Tokyo, 103-6128 (JP)**
• **KOKUBO, Maiko**
**Tokyo, 103-6128 (JP)**
• **KIMOTO, Yusuke**
**Tokyo, 103-6128 (JP)**

• **HARA, Shinji**
**Tokyo, 103-6128 (JP)**

(74) Representative: **Epping - Hermann - Fischer Patentanwaltsgesellschaft mbH**
**Schloßschmidstraße 5**
**80639 München (DE)**

(56) References cited:
**US-A- 4 667 179          US-A- 5 990 819**
**US-A1- 2011 309 956**

• **HIDALGO-LOPEZ JOSE A ET AL: "New Approaches for Increasing Accuracy in Readout of Resistive Sensor Arrays", IEEE SENSORS JOURNAL, IEEE, USA, vol. 17, no. 7, April 2017 (2017-04-01), pages 2154 - 2164, XP011642454, ISSN: 1530-437X, [retrieved on 20170308], DOI: 10.1109/JSEN.2017.2662803**
• **◆SCAR OBALLE-PEINADO ET AL: "Improved Circuits with Capacitive Feedback for Readout Resistive Sensor Arrays", SENSORS, vol. 16, no. 2, 25 January 2016 (2016-01-25), pages 149, XP055471787, DOI: 10.3390/s16020149**

**Description**

BACKGROUND

The disclosure relates to an element array circuit including an element array in which impedance elements are arranged, and to an electromagnetic wave sensor, a temperature sensor, and a strain sensor each including the element array circuit.

A resistor array circuit has been proposed that includes resistors arranged in a matrix. Such a resistor array circuit is usable, for example, as an infrared detection circuit. For example, reference is made to Japanese Unexamined Patent Application Publication (JP-A) No. H08-94443. Such an infrared detection circuit includes infrared-sensitive resistors arranged therein. Examples of the infrared-sensitive resistors may include a thermistor whose resistance value changes with changing temperature.

Document HIDALGO-LOPEZ JOSE AET AL: "New Approaches for Increasing Accuracy in Readout of Resistive Sensor Arrays", IEEE SENSORS JOURNAL, IEEE, USA, vol. 17, no. 7, 1 April 2017 (2017-04-01), pages 2154-2164, XP011642454, ISSN: 1530-437X, DOI: 10.1109/JSEN.2017.2662803 describes methods for connecting resistive sensor arrays using columns and rows in a 2-D structure. A first method involves introducing an additional column in order to eliminate the combined effect of the output resistance buffers for row selection, offset voltages and bias current of the operational amplifier. In a second method, a row of resistors is added in order to reduce the effect of finite gains.

SUMMARY

The invention is set out by the appended claims.

An element array circuit according to an embodiment of the disclosure includes one or more first wiring lines, a plurality of second wiring lines, a plurality of impedance elements, one or more operational amplifiers, one or more conversion elements, and one or more switchers. The second wiring lines each extend in a direction different from a direction in which the one or more first wiring lines each extend. The impedance elements are each coupled to both one of the one or more first wiring lines and one of the second wiring lines. The one or more operational amplifiers each include a positive input terminal, a negative input terminal, and an output terminal. The negative input terminal is couplable to one of the second wiring lines. The one or more conversion elements are each coupled to the negative input terminal and the output terminal of corresponding one of the one or more operational amplifiers, and each configured to convert a current flowing through one of the second wiring lines that is coupled to the negative input terminal into a voltage. The one or more switchers are each coupled to one of the one or more conversion elements in parallel between the negative input terminal and the output terminal of corresponding one of the one or more operational amplifiers, and are each configured to come into either a conducting state or a nonconducting state.

An electromagnetic wave sensor according to an embodiment of the disclosure includes the element array circuit.

A temperature sensor according to an embodiment of the disclosure includes the element array circuit.

A strain sensor according to an embodiment of the disclosure includes the element array circuit.

An element array circuit according to an embodiment of the disclosure includes a plurality of first wiring lines, one or more second wiring lines, a plurality of impedance elements, one or more operational amplifiers, one or more conversion elements, and one or more switchers. The one or more second wiring lines each extend in a direction different from a direction in which the first wiring lines each extend. The impedance elements are each coupled to both one of the first wiring lines and one of the one or more second wiring lines. The one or more operational amplifiers each include a positive input terminal, a negative input terminal, and an output terminal. The negative input terminal is couplable to one of the one or more second wiring lines. The one or more conversion elements are each coupled to the negative input terminal and the output terminal of corresponding one of the one or more operational amplifiers, and each configured to convert a current flowing through one of the one or more second wiring lines that is coupled to the negative input terminal into a voltage. The one or more switchers are each coupled to one of the one or more conversion elements in parallel between the negative input terminal and the output terminal of corresponding one of the one or more operational amplifiers, and are each configured to come into either a conducting state or a nonconducting state.

An element array circuit according to an embodiment of the disclosure includes a first wiring line, a second wiring line, an impedance element, an operational amplifier, and a processor. The second wiring line extends in a direction different from a direction in which the first wiring line extends. The impedance element is coupled to both the first wiring line and the second wiring line. The operational amplifier includes a positive input terminal, a negative input terminal, and an output terminal. The negative input terminal is couplable to the second wiring line. The processor is configured to perform charging of a parasitic capacitance parasitic to the second wiring line coupled to the negative input terminal, and measures, after performing the charging, an output voltage resulting from the impedance element and outputted from the output terminal.

BRIEF DESCRIPTION OF THE DRAWINGS

The accompanying drawings are included to provide a further understanding of the disclosure, and are incorporated in and constitute a part of this specification. The drawings illustrate embodiments and, together with the specification, serve to explain the principles of the disclosure.

FIG. 1 is a circuit diagram illustrating a configuration example of an element array circuit according to one example embodiment of the disclosure.

FIG. 2 is a flowchart describing an example measurement operation of the element array circuit illustrated in FIG. 1.

FIG. 3 is a circuit diagram describing a charging operation on a parasitic capacitance in the element array circuit illustrated in FIG. 1.

FIG. 4 is an explanatory diagram describing a change in output voltage in the element array circuit illustrated in FIG. 1.

FIG. 5 is a circuit diagram illustrating a configuration example of an element array circuit according to one example embodiment of the disclosure.

FIG. 6 is a circuit diagram illustrating a configuration example of an element array circuit according to one example embodiment of the disclosure.

FIG. 7 is a flowchart describing an example measurement operation of the element array circuit illustrated in FIG. 6.

FIG. 8 is a circuit diagram describing the charging operation on the parasitic capacitance in the element array circuit illustrated in FIG. 6.

FIG. 9 is a circuit diagram illustrating a configuration example of an element array circuit according to one example embodiment of the disclosure.

FIG. 10 is a schematic diagram illustrating a configuration example of a sensor device according to one example embodiment of the disclosure.

FIG. 11 is a circuit diagram illustrating a configuration example of an element array circuit according to a first modification example of one example embodiment of the disclosure.

FIG. 12 is a circuit diagram illustrating a configuration example of an element array circuit according to a second modification example of one example embodiment of the disclosure.

FIG. 13 is a circuit diagram illustrating a configuration example of an element array circuit according to a third modification example of one example embodiment of the disclosure.

FIG. 14 is a circuit diagram illustrating a configuration example of an element array circuit according to a fourth modification example of one example embodiment of the disclosure.

DETAILED DESCRIPTION

It is desirable that an element array circuit such as an infrared detection circuit provide a measured value related to, for example, a resistance value quickly with high accuracy.

It is desirable to provide an element array circuit that provides a measured value quickly with high accuracy, and an electromagnetic wave sensor, a temperature sensor, and a strain sensor that each include such an element array circuit.

In the following, some example embodiments of the disclosure are described in detail with reference to the accompanying drawings. Note that the following description is directed to illustrative examples of the disclosure and not to be construed as limiting to the disclosure. Factors including, without limitation, numerical values, shapes, materials, components, positions of the components, and how the components are coupled to each other are illustrative only and not to be construed as limiting to the disclosure. Further, elements in the following example embodiments which are not recited in a most-generic independent claim of the disclosure are optional and may be provided on an as-needed basis. The drawings are schematic and are not intended to be drawn to scale. Throughout the present specification and the drawings, elements having substantially the same function and configuration are denoted with the same reference numerals to avoid any redundant description. In addition, elements that are not directly related to any embodiment of the disclosure are unillustrated in the drawings. Note that the description is given in the following order.

1. First Example Embodiment: a first example of an element array circuit including column lines and operational amplifiers

2. Second Example Embodiment: a second example of the element array circuit including the column lines and the operational amplifiers

3. Third Example Embodiment: a first example of an element array circuit including a column line selector

4. Fourth Example Embodiment: a second example of the element array circuit including the column line selector

5. Fifth Example Embodiment: an example of a sensor device including the element array circuit

6. Modification Examples

[1. First Example Embodiment]

[Overall Configuration Example of Element Array Circuit 1]

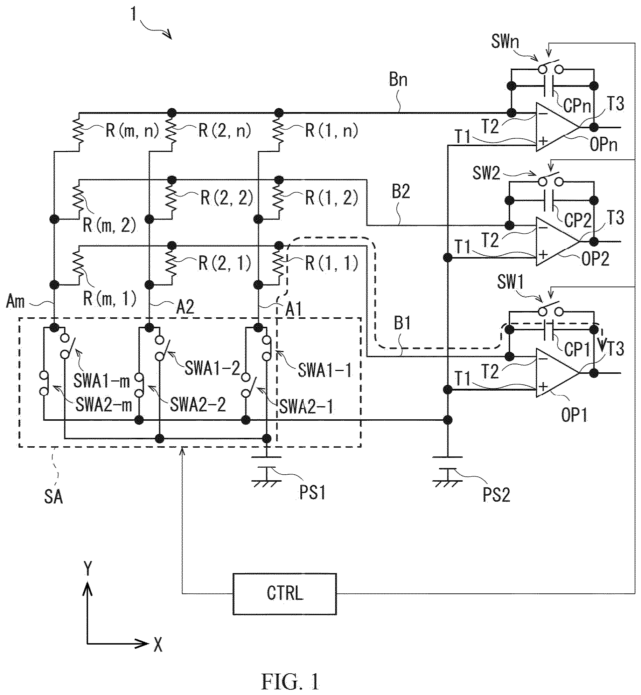

FIG. 1 is a circuit diagram schematically illustrating a configuration example of an element array circuit 1 according to a first example embodiment of the disclosure. The element array circuit 1 may be mountable on, for example, an infrared thermography, and may be configured to output an output voltage corresponding to an intensity of infrared rays applied to the element array circuit 1.

As illustrated in FIG. 1, the element array circuit 1 may include, for example, a plurality of row lines A denoted as A1 to Am in FIG. 1, a plurality of column lines B denoted as B1 to Bn in FIG. 1, a plurality of resistors R denoted as R(1, 1) to R(m, n) in FIG. 1, a row line selector SA, a plurality of operational amplifiers OP denoted as OP1 to OPn in FIG. 1, a plurality of capacitors CP denoted as CP1 to CPn in FIG. 1, a plurality of switches SW denoted as SW1 to SWn in FIG. 1, and a processor CTRL. Although FIG. 1 illustrates an example in which an m-number of row lines A are provided, any number of row lines A may be provided. Similarly, although FIG. 1 illustrates an example in which an n-number of column lines B are provided, any number of column lines B may be provided. Further, in FIG. 1, the resistor R coupled to both an "a"-th row line Aa among the m-number of row lines A1 to Am and a "b"-th column line Bb among the n-number of column lines B1 to Bn is denoted as R(a, b). The same applies to the drawings subsequent to FIG. 1. Further, the row lines A and the column lines B may not be in direct contact with each other.

[Row Line A]

The row lines A may correspond to a specific but non-limiting example of "one or more first wiring lines" in one embodiment of the disclosure.

The row lines A may each extend in a first direction and may be arranged to be adjacent to each other in a second direction different from the first direction. In the example embodiment illustrated in FIG. 1, the row lines A may each extend, for example, in a Y-axis direction and may be arranged to be adjacent to each other in an X-axis direction orthogonal to the Y-axis direction, although they are not limited thereto.

The row lines A may each have a first end that is couplable to a direct-current power supply PS1 via corresponding one of switches SWA1 of the row line selector SA, and also couplable to a direct-current power supply PS2 via corresponding one of switches SWA2 of the row line selector SA. In FIG. 1, the switches SWA1 are denoted as SWA1-1 to SWA1-m, and the switches SWA2 are denoted as SWA2-1 to SWA2-m. To each single row line A, multiple ones of resistors R may be coupled at their respective first ends. In the example embodiment illustrated in FIG. 1, n-number of resistors R may be coupled in parallel to each single row line A. In one example, the respective first ends of the resistors R(1, 1) to R(1, n) arranged in the Y-axis direction may be coupled to the row line A1 extending in the Y-axis direction. Similarly, the respective first ends of the resistors R(2, 1) to R(2, n) arranged in the Y-axis direction may be coupled to the row line A2 extending in the Y-axis direction, and the respective first ends of the resistors R(m, 1) to R(m, n) arranged in the Y-axis direction may be coupled to the row line Am extending in the Y-axis direction. In the example embodiment illustrated in FIG. 1, the row lines A may each have a second end opposite to the first end, and the respective second ends of the row lines A may be coupled to the respective first ends of the resistors R(1, n) to R(m, n) arranged in the X-axis direction.

For convenience, a resistor R selected from among the plurality of resistors R will be referred to as a selected resistor RS. A row line A corresponding to the selected resistor RS, among the plurality of row lines A, will be referred to as a selected row line AS. The row lines A other than the selected row line AS will each be referred to as an unselected row line AU. In performing measurement on the selected resistor RS, one of the switches SWA1 that corresponds to the selected row line AS may be caused to be in a conducting state to thereby cause a first voltage V1 to be applied to the selected row line AS from the direct-current power supply PS1. Further, in performing the measurement on the selected resistor RS, a second voltage V2 not equal to the first voltage V1 may be applied to all the unselected row lines AU from the direct-current power supply PS2 via ones of the switches SWA2 that correspond to the respective unselected row lines AU and are in the conducting state.

By way of example, FIG. 1 illustrates a state where the resistors R(1, 1) to R(1, n) are selected. For example, FIG. 1 illustrates a state where the switch SWA1-1 is in the conducting state to cause the first voltage V1 to be applied from the direct-current power supply PS1 to the selected row line A1 corresponding to the selected resistors R(1, 1) to R(1, n), and where the switches SWA2-2 to SWA2-m are in the conducting state to cause the second voltage V2 not equal to the first voltage V1 to be applied from the direct-current power supply PS2 to all the unselected row lines A2 to Am other than the selected row line A1. In this situation, the switches SWA1-2 to SWA1-m coupled to the unselected row lines A2 to Am may all be in a nonconducting state, and the switch SWA2-1 coupled to the selected row line A1 may also be in the nonconducting state. Either the first voltage V1 or the second voltage V2 may be 0 V.

[Column Line B]

The column lines B may correspond to a specific but non-limiting example of "a plurality of second wiring lines" in one embodiment of the disclosure.

The column lines B each extend in a direction different from the direction in which the row lines A each extend. For example, the column lines B may each extend in the second direction, and may be arranged to be adjacent to each other in the first direction different from the second direction. In the example embodiment illustrated in FIG. 1, the column lines B may each extend, for example, in the X-axis direction and may be arranged to be adjacent to each other in the Y-axis direction, although they are not limited thereto.

The column lines B may each have a first end coupled to corresponding one of the operational amplifiers OP. For example, the first end of the column line B1 may be coupled to a negative input terminal T2 of the operational amplifier OP1, the first end of the column line B2 may be coupled to the negative input terminal T2 of the operational amplifier OP2, and the first end of the column line Bn may be coupled to the negative input terminal T2 of the operational amplifier OPn.

To each single column line B, multiple ones of the resistors R may be coupled at their respective second ends. The respective second ends of the resistors R may be opposite to the respective first ends each coupled to corresponding one of the row lines A. In the example embodiment illustrated in FIG. 1, m-number of resistors R may be coupled in parallel to each single column line B. In one example, the respective second ends of the resistors R(1, 1) to R(m, 1) arranged in the X-axis direction may be coupled to the column line B1 extending in the X-axis direction. Similarly, the respective second ends of the resistors R(1, 2) to R(m, 2) arranged in the X-axis direction may be coupled to the column line B2 extending in the X-axis direction, and the respective second ends of the resistors R(1, n) to R(m, n) arranged in the X-axis direction may be coupled to the column line Bn extending in the X-axis direction. In the example embodiment illustrated in FIG. 1, the column lines B may each have a second end opposite to the first end, and the respective second ends of the column lines B may be coupled to the respective second ends of the resistors R(m, 1) to R(m, n) arranged in the Y-axis direction.

[Resistor R]

The resistors R may correspond to a specific but non-limiting example of "a plurality of impedance elements" in one embodiment of the disclosure.

The resistors R may each be coupled to both one of the row lines A and one of the column lines B. The resistors R may each have the first end coupled to the one of the row lines A, and the second end coupled to the one of the column lines B. As described above, in the example embodiment illustrated in FIG. 1, n-number of resistors R may be coupled to each single row line A, and m-number of resistors R may be coupled to each single column line B. The number of the resistors R coupled to both one of the row lines A and one of the column lines B is one. Accordingly, it is possible to specify a single resistor R by selecting one row line A from among the plurality of row lines A and selecting one column line B from among the plurality of column lines B.

The resistor R may be a component of an infrared light receiving device that converts infrared rays condensed by, for example, a lens into an electric signal. In one example, the resistor R may include a resistance change layer whose resistance changes with changing temperature, for example. Examples of the resistance change layer may include a thermistor film. The thermistor film may include, for example, vanadium oxide, amorphous silicon, polycrystalline silicon, a manganese-containing oxide having a spinel crystal structure, titanium oxide, or yttrium-barium-copper oxide. The resistor R may further include an infrared absorption layer adjacent to the thermistor film. The infrared absorption layer may absorb infrared rays and generate heat. The infrared absorption layer may include, for example, silicon oxide ($SiO_2$), aluminum oxide ($AlO_3$), silicon nitride ($Si_3N_4$), or aluminum nitride (AlN). In the resistor R, temperatures of the infrared absorption layer and the resistance change layer may change with intensity of received infrared rays, and as a result, the resistance change layer may change in resistance value.

[Row Line Selector SA]

The row line selector SA may include the switches SWA1 (SWA1-1 to SWA1-m) and the switches SWA2 (SWA2-1 to SWA2-m). The switches SWA1 (SWA1-1 to SWA1-m) and the switches SWA2 (SWA2-1 to SWA2-m) may each be switchable between the conducting state and the nonconducting state. The switches SWA1 (SWA1-1 to SWA1-m) may each be provided between corresponding one of the row lines A (A1 to Am) and the direct-current power supply PS1. The switches SWA2 (SWA2-1 to SWA2-m) may each be provided between corresponding one of the row lines A (A1 to Am) and the direct-current power supply PS2.

The row line selector SA may select one row line A to be the selected row line AS, from among the plurality of row lines A. The row line selector SA may couple the selected row line AS to the direct-current power supply PS1, and may couple the unselected row lines AU other than the selected row line AS to the direct-current power supply PS2. The direct-current power supply PS1 may apply the first voltage V1 to the selected row line AS. The direct-current power supply PS2 may apply the second voltage V2 to the unselected row lines AU. The second voltage V2 may be different from the first voltage V1. Operation of the row line selector SA may be controlled by the processor CTRL. For example, a switching operation of the row line selector SA on each of the switches SWA1 (SWA1-1 to SWA1-m) and each of the switches SWA2 (SWA2-1 to SWA2-m) may be executed based on a command from the processor CTRL.

[Operational Amplifier OP]

The operational amplifiers OP may each be coupled to corresponding one of the column lines B. The operational amplifiers OP, which are denoted as OP1 to OPn in FIG. 1, each include a positive input terminal T1, the negative input terminal T2, and an output terminal T3. The positive input terminal T1 may be coupled to the direct-current power supply PS2, and the second voltage V2 may be applied to the positive input terminal T1. The negative input terminal T2 may be coupled to the corresponding one of the column lines B. Each of the operational amplifiers OP may operate to cause the positive input terminal T1 and the negative input terminal T2 to be at the same potential, and accordingly, the potential at the negative input terminal T2 may become substantially equal to the second voltage V2. The output terminal T3 may be coupled to the negative input terminal T2 via corresponding one of the capacitors CP.

[Capacitor CP]

The capacitors CP may correspond to a specific but non-limiting example of "one or more conversion elements" in one embodiment of the disclosure.

The capacitors CP are each coupled to both the negative input terminal T2 and the output terminal T3 of corresponding one of the operational amplifiers OP, and each convert a current flowing through one of the column lines B that is coupled to the negative input terminal T2 into a voltage. For example, in the example embodiment illustrated in FIG. 1, the capacitor CP1 may be coupled to both the negative input terminal T2 and the output terminal T3 of the operational amplifier OP1 and may convert a current flowing through the column line B1 into a voltage. Similarly, the capacitor CP2 may be coupled to both the negative input terminal T2 and the output terminal T3 of the operational amplifier OP2 and may convert a current flowing through the column line B2 into a voltage; and the capacitor CPn may be coupled to both the negative input terminal T2 and the output terminal T3 of the operational amplifier OPn and may convert a current flowing through the column line Bn into a voltage

[Switch SW]

The switches SW may correspond to a specific but non-limiting example of "one or more switchers" in one embodiment of the disclosure.

The switches SW may each be coupled to corresponding one of the operational amplifiers OP. The switches SW are each coupled to corresponding one of the capacitors CP in parallel between the negative input terminal T2 and the output terminal T3 of the corresponding one of the operational amplifiers OP. The switches SW are each configured to come into either a conducting state or a nonconducting state. For example, in the example embodiment illustrated in FIG. 1, the switch SW1 is coupled to the capacitor CP1 in parallel between the negative input terminal T2 and the output terminal T3 of the operational amplifier OP1 and is configured to come into either the conducting state or the nonconducting state. Similarly, the switch SW2 is coupled to the capacitor CP2 in parallel between the negative input terminal T2 and the output terminal T3 of the operational amplifier OP2 and is configured to come into either the conducting state or the nonconducting state. The switch SWn is coupled to the capacitor CPn in parallel between the negative input terminal T2 and the output terminal T3 of the operational amplifier OPn and is configured to come into either the conducting state or the nonconducting state.

[Processor CTRL]

The processor CTRL may be a microcomputer, for example. The processor CTRL may execute predetermined control processing by causing a central processing unit (CPU) to execute a control program. The processor CTRL may control, for example, a switching operation on each of the switches SW. The processor CTRL may execute a control of: performing charging of a parasitic capacitance parasitic to each of the column lines B; and switching, after performing the charging, one switch SW corresponding to relevant one of the column lines B into the nonconducting state. The processor CTRL may perform the charging of the parasitic capacitance of each of the column lines B by causing the one switch SW corresponding to the relevant one of the column lines B to be in the conducting state and by establishing electrical continuity between: the column line B coupled to the negative input terminal T2 of corresponding one of the operational amplifiers OP; and the output terminal T3 of the corresponding one of the operational amplifier OP.

Further, the processor CTRL may control the switching operation of the row line selector SA. For example, the processor CTRL may cause one switch SWA1 corresponding to the selected row line AS to be in the conducting state and cause the other switches SWA1 corresponding to the unselected row lines AU to be in the nonconducting state. The selected row line As may be one row line A corresponding to the selected resistor RS. The unselected row lines AU may be all the row lines A excluding the selected row line AS.

After performing the charging of the parasitic capacitance of each of the column lines B, the processor CTRL may switch the one switch SW corresponding to the relevant one of the column lines B into the nonconducting state, and may measure an output voltage outputted from the output terminal T3 of one operational amplifier OP corresponding to the relevant one of the column lines B, the output voltage resulting from the selected resistor RS coupled to both the selected row line AS and the relevant one of the column lines B.

A period of time over which the parasitic capacitance of each of the column lines B is to be charged by causing the one switch SW corresponding to the relevant one of the column lines B to be in the conducting state may be longer than a period of time that allows electric charge of one capacitor CP corresponding to the relevant one of the column lines B to be discharged almost completely. For example, the above-described period of time may be longer than five times a product of a capacitance value of the one capacitor CP corresponding to the relevant one of the column lines B and a resistance value of the one switch SW corresponding to the capacitor CP when the switch SW is in the conducting state. Further, the period of time over which the parasitic capacitance of each of the column lines B is to be charged by causing the one switch SW corresponding to the relevant one of the column lines B to be in the conducting state may be longer than five times the product of a capacitance value of the parasitic capacitance of the relevant one of the column lines B and the resistance value of the one switch SW corresponding to the relevant one of the column lines B. One reason for this is that such a length of time allows the parasitic capacitance of each of the column lines B to be sufficiently charged and thus allows for accurate measurement of the output voltage resulting from each of the selected resistors RS.

The direct-current power supplies PS1 and PS2 may each be provided inside the element array circuit 1 or outside the element array circuit 1.

[Measurement Operation in Element Array Circuit 1]

In the element array circuit 1, it is possible to perform measurement on each of the resistors R in the following manner, for example. The following measurement operation may be performed in accordance with a command from the processor CTRL.

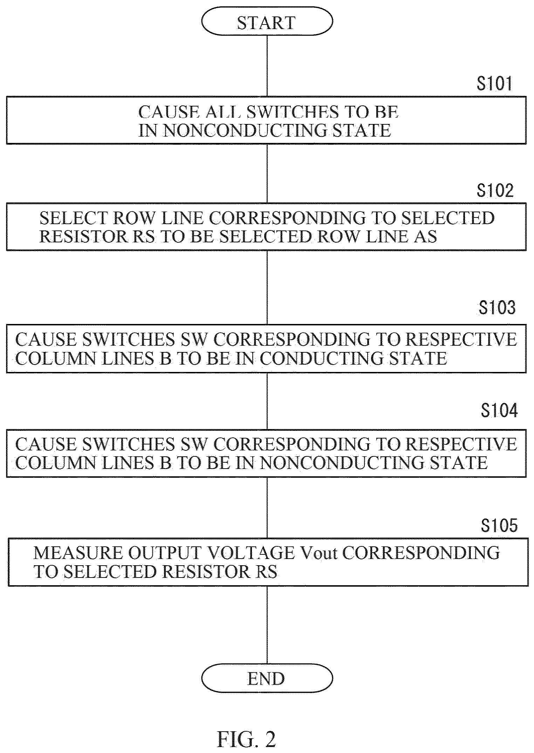

FIG. 2 is a flowchart describing an example measurement operation of the element array circuit 1. First, all the switches may be caused to be in the nonconducting state (step S101). For example, the switches SW1 (SW1 to SWn), the switches SWA1 (SWA1-1 to SWA1-m), and the switches SWA2 (SWA2-1 to SWA2-m) illustrated in FIG. 1 may all be caused to be in the nonconducting state, i.e., an open state.

Thereafter, one row line corresponding to the selected resistor RS targeted for the measurement may be selected to be the selected row line AS (step S102). For example, the switch SWA1 corresponding to the selected row line AS to which the selected resistor RS is coupled may be caused to be in the conducting state to thereby cause the first voltage V1 to be applied to the selected row line AS. The other switches SWA1 corresponding to the unselected row lines AU may be kept in the nonconducting state. Further, the switches SWA2 corresponding to the unselected row lines AU may be caused to be in the conducting state to thereby cause the second voltage V2 to be applied to the unselected row lines AU. The switch SWA2 corresponding to the selected row line AS may be kept in the nonconducting state. FIG. 1 illustrates an example state where the resistors R(1, 1) to R(1, n) are selected as the selected resistors RS. In this case, the switch SWA1-1 corresponding to the row line A1 as the selected row line AS may be caused to be in the conducting state to thereby cause the first voltage V1 to be applied to the row line A1. The switches SWA1-2 to SWA1-m corresponding to the row lines A2 to Am as the unselected row lines AU may be kept in the nonconducting state. Further, the switches SWA2-2 to SWA2-m corresponding to the row lines A2 to Am as the unselected row lines AU may be caused to be in the conducting state to thereby cause the second voltage V2 to be applied to the row lines A2 to Am. The switch SWA2-1 corresponding to the row line A1 as the selected row line AS may be kept in the nonconducting state.

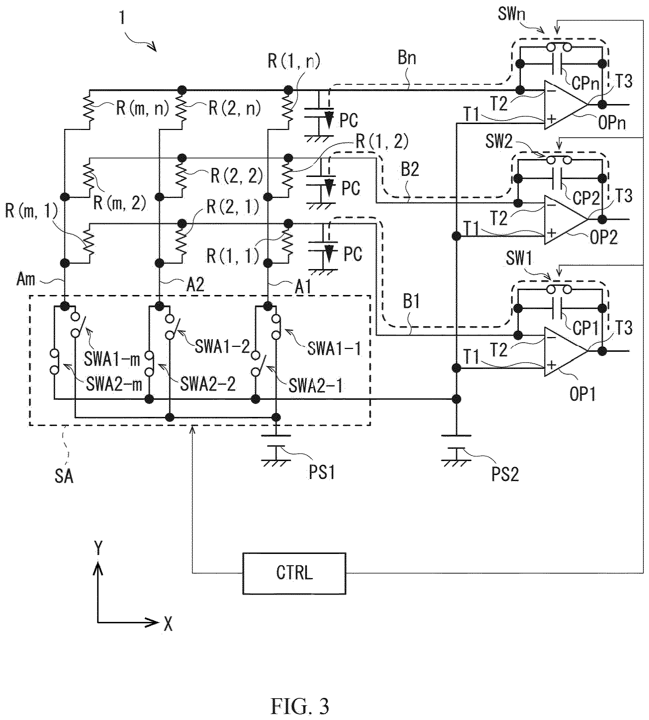

Thereafter, the switches SW corresponding to the respective column lines B may be caused to be in the conducting state (step S103) to allow for charging of the parasitic capacitances parasitic to the respective column lines B. For example, for each of the column lines B, one switch SW corresponding thereto may be caused to be in the conducting state to thereby establish electrical continuity between: the column line B coupled to the negative input terminal T2 of corresponding one of the operational amplifiers OP; and the output terminal T3 of the corresponding one of the operational amplifier OP. In the example embodiment illustrated in FIG. 1, the switch SW1 corresponding to the column line B1 to which the resistor R(1, 1) as the selected resistor RS is coupled may be caused to be in the conducting state to thereby establish electrical continuity between the negative input terminal T2 and the output terminal T3 of the operational amplifier OP1. Similarly, the switch SW2 corresponding to the column line B2 to which the resistor R(1, 2) as the selected resistor RS is coupled may be caused to be in the conducting state to thereby establish electrical continuity between the negative input terminal T2 and the output terminal T3 of the operational amplifier OP2; and the switch SWn corresponding to the column line Bn to which the resistor R(1, n) as the selected resistor RS is coupled may be caused to be in the conducting state to thereby establish electrical continuity between the negative input terminal T2 and the output terminal T3 of the operational amplifier OPn. FIG. 3 illustrates a circuit diagram describing a charging operation on a parasitic capacitance PC in the element array circuit 1. As indicated in broken-line arrows in FIG. 3, causing the switch SW1 to be in the conducting state allows a current to flow through the column line B1 from the operational amplifier OP1, thus allowing for charging of the parasitic capacitance PC parasitic to the column line B1. Similarly, causing the switch SW2 to be in the conducting state allows for charging of the parasitic capacitance PC parasitic to the column line B2, and causing the switch SWn to be in the conducting state allows for charging of the parasitic capacitance PC parasitic to the column line Bn. Here, the parasitic capacitance PC of each of the column lines B may be charged by causing one switch SW corresponding to relevant one of the column lines B to be in the conducting state over a period of time longer than a period of time that allows electric charge of one capacitor CP corresponding to the relevant one of the column lines B to be discharged almost completely. For example, the parasitic capacitance PC of the column line B1 may be charged by causing the switch SW1 to be in the conducting state over a period of time longer than five times the product of the capacitance value of the capacitor CP1 and the resistance value of the switch SW1, that is, five times a time constant. Causing the switch SW1 to be in the conducting state over a period of time as long as five times the product of the capacitance value of the capacitor CP1 and the resistance value of the switch SW1 allows 99.3% of the electric charge of the capacitor CP1 to be discharged. Similarly, the parasitic capacitance PC of the column line B2 may be charged by causing the switch SW2 to be in the conducting state over a period of time longer than five times the product of the capacitance value of the capacitor CP2 and the resistance value of the switch SW2; and the parasitic capacitance PC of the column line Bn may be charged by causing the switch SWn to be in the conducting state over a period of time longer than five times the product of the capacitance value of the capacitor CPn and the resistance value of the switch SWn. Further, the parasitic capacitance PC of each of the column lines B may be charged by causing one switch SW corresponding to relevant one of the column lines B to be in the conducting state over a period of time longer than five times the product of the capacitance value of the parasitic capacitance PC of the relevant one of the column lines B and the resistance value of the one switch SW corresponding to the relevant one of the column lines B. One reason for this is that such a length of time allows the parasitic capacitance PC of each of the column lines B to be sufficiently charged and thus allows for accurate measurement of the output voltage resulting from each of the selected resistors RS. The parasitic capacitance PC of the column line B1 may be charged by causing the switch SW1 to be in the conducting state over a period of time longer than five times the product of the capacitance value of the parasitic capacitance PC of the column line B1 and the resistance value of the switch SW1, that is, five times the time constant. Similarly, the parasitic capacitance PC of the column line B2 may be charged by causing the switch SW2 to be in the conducting state over a period of time longer than five times the product of the capacitance value of the parasitic capacitance PC of the column line B2 and the resistance value of the switch SW2; and the parasitic capacitance PC of the column line Bn may be charged by causing the switch SWn to be in the conducting state over a period of time longer than five times the product of the capacitance value of the parasitic capacitance PC of the column line Bn and the resistance value of the switch SWn.

Thereafter, the switches SW corresponding the respective column lines B may be caused to be in the nonconducting state (step S104). This may end the charging of the parasitic capacitances PC of the respective column lines B that has been performed by causing the switches SW corresponding to the respective column lines B to be in the conducting state. In the example embodiment illustrated in FIG. 1, the switch SW1 corresponding to the column line B1 may be switched into the nonconducting state. Similarly, the switch SW2 corresponding to the column line B2 may be switched into the nonconducting state, and the switch SWn corresponding to the column line Bn may be switched into the nonconducting state. At this time, because the potential at the negative input terminal T2 of each of the operational amplifiers OP may be equal to the second voltage V2, a difference voltage between the first voltage V1 and the second voltage V2, i.e., V2 - V1, may be applied to the resistors R(1, 1) to R(1, n), and currents dependent on the respective resistance values of the resistors R(1, 1) to R(1, n) may flow through the respective resistors R(1, 1) to R(1, n) and through the respective column lines B1 to Bn toward the respective capacitors CP1 to CPn. In contrast, the second voltage V2 may be applied to each of the row lines A2 to Am other than the row line A1 as the selected row line AS, and to each of the column lines B1 to Bn. Accordingly, the voltage to be applied to the resistors R other than the resistors R(1, 1) to R(1, n) as the selected resistors RS may be zero, resulting in no current flowing through the resistors R other than the resistors R(1, 1) to R(1, n).

Thereafter, output voltages corresponding to the respective selected resistors RS may be measured (step S105). For example, an output voltage may be measured that results from each selected resistor RS coupled to both the selected row line AS and one of the column lines B and that is outputted from the output terminal T3 of one of the operational amplifiers OP corresponding to the one of the column lines B. In the example embodiment illustrated in FIG. 1, an output voltage Vout outputted from the output terminal T3 of the operational amplifier OP1 corresponding to the resistor R(1, 1) coupled to both the row line A1 and the column line B1 may be measured. Similarly, an output voltage Vout outputted from the output terminal T3 of the operational amplifier OP2 corresponding to the resistor R(1, 2) coupled to both the row line A1 and the column line B2 may be measured; and an output voltage Vout outputted from the output terminal T3 of the operational amplifier OPn corresponding to the resistor R(1, n) coupled to both the row line A1 and the column line Bn may be measured. Currents flowing through the respective column lines B1 to Bn may be converted into voltages by the respective capacitors CP1 to CPn, and may be outputted as the output voltages Vout from the output terminals T3 of the operational amplifiers OP1 to OPn corresponding to the respective resistors R(1, 1) to R(1, n). The output voltages Vout may each be describable as in Expression (1) below.

$$\text{Vout [V]} = \{(V2 \text{ [V]} - V1 \text{ [V]})/(cs \text{ [F]} \times rs \text{ [}\Omega\text{]})\} \times T \text{ [sec.]} + V2 \text{ [V]} \quad ...... \text{ (1)}$$

where:

V1 [V] represents the first voltage to be applied to the selected row line AS;
V2 [V] represents the second voltage to be applied to the positive input terminal T1;
cs [F] represents the capacitance value of one of the capacitors CP that corresponds to relevant one of the column lines B;
rs [$\Omega$] represents the resistance value of one of the selected resistors RS that corresponds to the relevant one of the column lines B;
T [sec.] represents an elapsed period of time after one of the switches SW that corresponds to the relevant one of the column lines B is caused to be in the nonconducting state; and
Vout [V] represents an output voltage, after a lapse of T [sec.], of one of the operational amplifiers OP that corresponds to the relevant one of the column lines B.

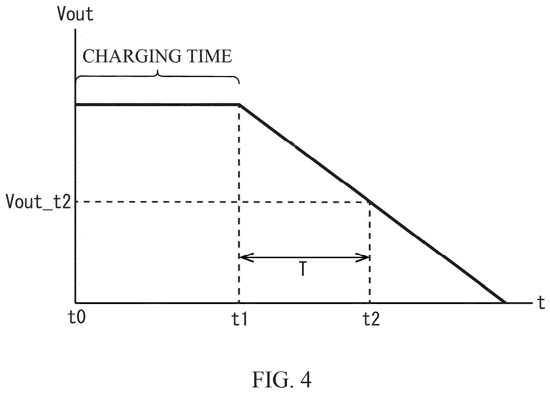

FIG. 4 is an explanatory diagram that describes a change in the output voltage Vout outputted from the output terminal T3 of the operational amplifier OP1 in the element array circuit 1. In FIG. 4, the horizontal axis represents time t, and the vertical axis represents the output voltage Vout. In FIG. 4, a time t0 is a time at which the charging of the parasitic capacitance PC of the column line B1 is started by switching the switch SW1 into the conducting state in step S103. In FIG. 4, a time t1 is a time at which the charging of the parasitic capacitance PC of the column line B1 is ended by switching the switch SW1 into the nonconducting state in step S104. Accordingly, a period of time from the time t0 to the time t1 may be a charging time for the parasitic capacitance PC of the column line B1. In FIG. 4, a time t2 is a time at which an output voltage Vout_t2 is measured upon a lapse of time T from the time T1. FIG. 4 illustrates an example in which the first voltage V1 may be greater than the second voltage V2, and the output voltage Vout may gradually decrease with a lapse of time from the time t1. Because the capacitance value cs [F] of the capacitor CP is known, the output voltage Vout may be dependent on the resistance value rs [$\Omega$] of the selected resistor RS, as indicated in Expression (1) above. Accordingly, the resistance value rs of each of the selected resistors RS is calculable from the output voltage Vout_t2 at the time t2, based on Expression (1) above.

The measurement operation in the element array circuit 1 may thus be completed. When measuring the output voltage Vout corresponding to any of the resistors R other than the resistors R(1, 1) to R(1, n), steps S101 to S105 described above may be repeated. However, for the column line B to which the resistor R having undergone the measurement is coupled, the operation of charging the parasitic capacitance thereof again may be omitted. Further, in some embodiments, the order of steps S102 and S103 may be reversed, or step S102 may be performed between step S104 and step S105.

[Example Workings and Example Effects of Element Array Circuit 1]

As described above, the element array circuit 1 according to the present example embodiment includes the one or more row lines A, the plurality of column lines B, the plurality of resistors R, the one or more operational amplifiers OP, the one or more capacitors CP, and the one or more switches SW. The column lines B each extend in a direction different from the direction in which the one or more row lines A extend. The resistors R are each coupled to both one of the one or more row lines A and one of the column lines B. The one or more operational amplifiers OP each include the positive input terminal T1, the negative input terminal T2, and the output terminal T3. The negative input terminal T2 is couplable to one of the column lines B. The one or more capacitors CP are each coupled to the negative input terminal T2 and the output terminal T3 of corresponding one of the one or more operational amplifiers OP, and each convert a current flowing through the column line B coupled to the negative input terminal T2 into a voltage. The one or more switches SW are each coupled to one of the one or more capacitors CP in parallel between the negative input terminal T2 and the output terminal T3 of corresponding one of the one or more operational amplifiers OP, and are each configured to come into either the conducting state or the nonconducting state. In the element array circuit 1 of such a configuration, by causing one switch SW corresponding to each column line B into the conducting state and by establishing electrical continuity between: the column line B coupled to the negative input terminal T2 of corresponding one of the operational amplifier OP; and the output terminal T3 of the corresponding one of the operational amplifier OP, the parasitic capacitance parasitic to the column line B coupled to the negative input terminal T2 of the corresponding one of the operational amplifier OP is charged quickly. Upon switching the switch SW into the nonconducting state after the charging, it is possible to measure the output voltage Vout that results from relevant one of the selected resistors RS and is outputted from the output terminal T3 of the operational amplifier OP corresponding to the relevant one of the selected resistors RS.

In contrast, in the infrared detection circuit of JP-A No. H08-94443, for example, a low-pass filter is formed by a resistor (a resistor element $Rt_{mn}$) and a parasitic capacitance parasitic to a wiring line coupled to the resistor and a negative input terminal of an operational amplifier. Due to an influence of such a low-pass filter, a potential at the negative input terminal of the operational amplifier to which the wiring line is coupled can take a long time to reach a steady state as a result of charging of the parasitic capacitance, and accordingly, an output voltage value resulting from the resistor can take a long time to reach a steady state. To measure the resistance value of the resistor with accuracy, it would thus be necessary to wait for the long time until the output voltage value reaches the steady state. An output voltage value before reaching the steady state could be measured, but with low accuracy.

In this regard, the element array circuit 1 according to the present example embodiment is provided with the switches SW, which allows for quick charging of the parasitic capacitances parasitic to the respective column lines B. This helps to bring the output voltages Vout resulting from the selected resistors RS coupled to the respective column lines B into a steady state quickly, thus allowing for quick and accurate measurement of the output voltages Vout related to the resistance values of the respective selected resistors RS.

Moreover, the element array circuit 1 according to the present example embodiment may be provided with a plurality of operational amplifiers OP, the operational amplifiers OP corresponding to the respective column lines B. This helps to measure the output voltages Vout quickly as compared with, for example, when any of the column lines B is selectively coupled to a single operational amplifier OP to measure the output voltage Vout.

[2. Second Example Embodiment]

[Overall Configuration Example of Element Array Circuit 2]

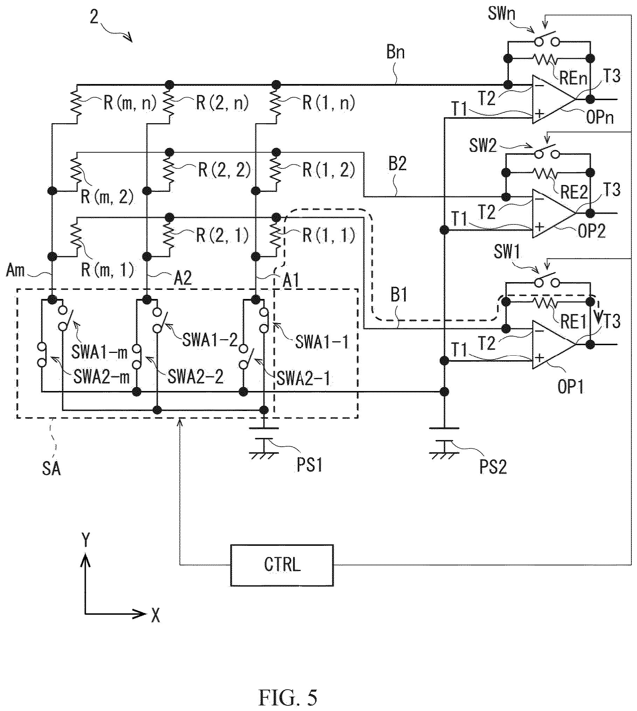

FIG. 5 is a circuit diagram schematically illustrating an overall configuration example of an element array circuit 2 according to a second example embodiment of the disclosure. As illustrated in FIG. 5, the element array circuit 2 may have a configuration substantially the same as that of the element array circuit 1 of the first example embodiment illustrated in FIG. 1, except for including a plurality of resistors RE, instead of the capacitors CP, as the plurality of conversion elements. In FIG. 5, the resistors RE are denoted as RE1 to REn. The following description will thus focus on the resistors RE, and descriptions of the other components will be omitted as appropriate.

[Resistor RE]

The resistors RE may correspond to a specific but non-limiting example of "one or more conversion elements" in one embodiment of the disclosure, and may each correspond to a specific but non-limiting example of a "first resistor" in one embodiment of the disclosure. The resistors RE may each include a resistor element including, for example, a metal material having a predetermined specific resistance. The resistors RE are each coupled to both the negative input terminal T2 and the output terminal T3 of corresponding one of the operational amplifiers OP, and each convert a current flowing through the column line B coupled to the negative input terminal T2 into a voltage. For example, in the example embodiment illustrated in FIG. 5, the resistor RE1 is coupled to both the negative input terminal T2 and the output terminal T3 of the operational amplifier OP1 and converts a current flowing through the column line B1 into a voltage. Similarly, the resistor RE2 is coupled to both the negative input terminal T2 and the output terminal T3 of the operational amplifier OP2 and converts a current flowing through the column line B2 into a voltage; and the resistor REn is coupled to both the negative input terminal T2 and the output terminal T3 of the operational amplifier OPn and converts a current flowing through the column line Bn into a voltage. The resistors RE each have a resistance value greater than a resistance value of corresponding one of the switches SW.

[Measurement Operation in Element Array Circuit 2]

In the element array circuit 2, it is possible to perform measurement on each of the resistors R in the following manner, for example. The following measurement operation may be performed in accordance with a command from the processor CTRL.

The measurement operation in the element array circuit 2 may be basically the same as the measurement operation in the element array circuit 1. See FIG. 2. For example, as illustrated in FIG. 2, charging of the parasitic capacitances parasitic to the respective column lines B may be performed quickly in step S103 before performing measurement on the resistors R. In one example, in the present example embodiment illustrated in FIG. 5, the switch SW1 corresponding to the column line B1 to which the resistor R(1, 1) as the selected resistor RS is coupled may be caused to be in the conducting state to thereby establish electrical continuity between the negative input terminal T2 and the output terminal T3 of the operational amplifier OP1. Similarly, the switch SW2 corresponding to the column line B2 to which the resistor R(1, 2) as the selected resistor RS is coupled may be caused to be in the conducting state to thereby establish electrical continuity between the negative input terminal T2 and the output terminal T3 of the operational amplifier OP2; and the switch SWn corresponding to the column line Bn to which the resistor R(1, n) as the selected resistor RS is coupled may be caused to be in the conducting state to thereby establish electrical continuity between the negative input terminal T2 and the output terminal T3 of the operational amplifier OPn. This allows for charging of each of the parasitic capacitance parasitic to the column line B1, the parasitic capacitance parasitic to the column line B2, and the parasitic capacitance parasitic to the column line Bn. As with the first example embodiment, the period of time over which the parasitic capacitance PC of each of the column lines B is to be charged by causing one switch SW corresponding to relevant one of the column lines B to be in the conducting state may be longer than five times the product of the capacitance value of the parasitic capacitance PC of the relevant one of the column lines B and the resistance value of the one switch SW corresponding to the relevant one of the column lines B.

Thereafter, the switches SW corresponding the respective column lines B may be caused to be in the nonconducting state (step S104). This may end the charging of the parasitic capacitances PC of the respective column lines B that has been performed by causing the switches SW corresponding to the respective column lines B to be in the conducting state. In the example embodiment illustrated in FIG. 5, the switch SW1 corresponding to the column line B1 may be switched into the nonconducting state. Similarly, the switch SW2 corresponding to the column line B2 may be switched into the nonconducting state, and the switch SWn corresponding to the column line Bn may be switched into the nonconducting state. At this time, the difference voltage between the first voltage V1 and the second voltage V2, i.e., V2 - V1, may be applied to the resistors R(1, 1) to R(1, n), and currents dependent on the respective resistance values of the resistors R(1, 1) to R(1, n) may flow through the respective resistors R(1, 1) to R(1, n), through the respective column lines B1 to Bn, and through the respective resistors RE1 to REn. In FIG. 5, a broken-line arrow indicates how the current dependent on the resistance value of the resistor R(1, 1) flows to the resistor RE1. In contrast, the second voltage V2 may be applied to each of the row lines A2 to Am other than the row line A1 as the selected row line AS, and to each of the column lines B1 to Bn. Accordingly, the voltage to be applied to the resistors R other than the resistors R(1, 1) to R(1, n) as the selected resistors RS may be zero, resulting in no current flowing through the resistors R other than the resistors R(1, 1) to R(1, n). Thereafter, the output voltages corresponding to the respective selected resistors RS may be measured (step S105). For example, the output voltage resulting from each selected resistor RS coupled to both the selected row line AS and one of the column lines B may be measured, the output voltage being outputted from the output terminal T3 of one of the operational amplifiers OP corresponding to the one of the column lines B. Currents flowing through the respective column lines B1 to Bn may be converted into voltages by the respective resistors RE1 to REn, and may be outputted as the output voltages Vout from the output terminals T3 of the operational amplifiers OP1 to OPn corresponding to the respective resistors R(1, 1) to R(1, n). The output voltages Vout may each be describable as in Expression (2) below.

$$\text{Vout [V]} = (\text{re } [\Omega]/\text{rs } [\Omega]) \times (\text{V2 [V]} - \text{V1 [V]}) + \text{V2 [V]} \quad ...... (2)$$

where:

V1 [V] represents the first voltage to be applied to the selected row line AS;
V2 [V] represents the second voltage to be applied to the positive input terminal T1;
re [$\Omega$] represents the resistance value of one of the resistors RE that corresponds to relevant one of the column lines B;
rs [$\Omega$] represents the resistance value of one of the selected resistors RS that corresponds to the relevant one of the column lines B; and
Vout [V] represents the output voltage of one of the operational amplifiers OP that corresponds to the relevant one of the column lines B.

Because the resistance value re [$\Omega$] of the resistor RE1 is known, the output voltage Vout may be dependent on the resistance value rs [$\Omega$] of the selected resistor RS, as indicated in Expression (2) above. Accordingly, the resistance value rs of each of the selected resistors RS is calculable from the output voltage Vout, based on Expression (2) above.

[Example Workings and Example Effects of Element Array Circuit 2]

The element array circuit 2 according to the second example embodiment is expected to provide effects similar to those of the element array circuit 1 according to the foregoing first example embodiment. For example, the element array circuit 2 according to the second example embodiment is provided with the switches SW, which allows for quick charging of the parasitic capacitances parasitic to the respective column lines B. This helps to bring the output voltages Vout resulting from the selected resistors RS coupled to the respective column lines B into a steady state quickly, thus allowing for quick and accurate measurement of the output voltages Vout related to the resistance values of the respective selected resistors RS.

Moreover, the element array circuit 2 according to the second example embodiment may be provided with a plurality of operational amplifiers OP, the operational amplifiers OP corresponding to the respective column lines B. This helps to measure the output voltages Vout quickly as compared with, for example, when any of the column lines B is selectively coupled to a single operational amplifier OP to measure the output voltage Vout.

[3. Third Example Embodiment]

[Overall Configuration Example of Element Array Circuit 3]

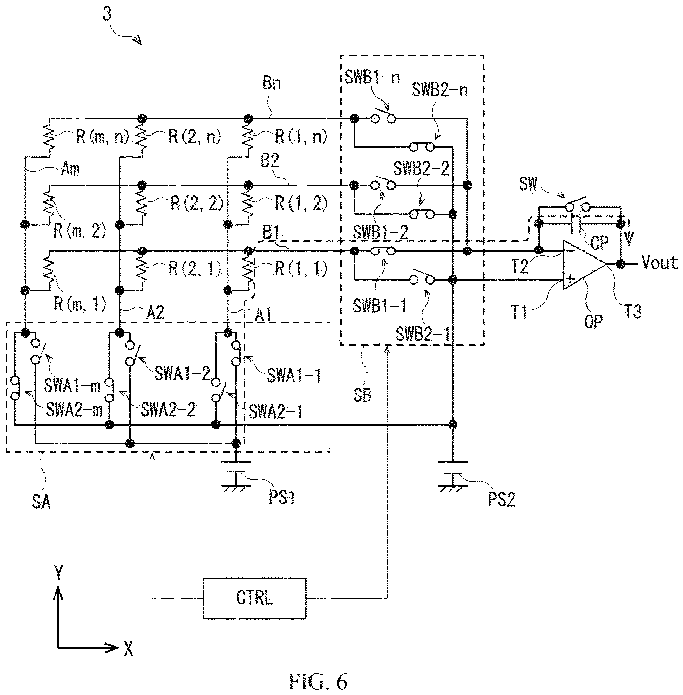

FIG. 6 is a circuit diagram schematically illustrating a configuration example of an element array circuit 3 according to a third example embodiment of the disclosure. As illustrated in FIG. 6, the element array circuit 3 may have a configuration different from the configuration of the element array circuit 1 of FIG. 1 in that a column line selector SB is further provided and the respective numbers of the switches SW, the capacitors CP, and the operational amplifiers OP are each set to one. The following description will thus focus on the column line selector SB, and descriptions of the other components will be omitted as appropriate. It is to be noted that although FIG. 6 illustrates an example in which m-number of row lines A are provided, any number of row lines A may be provided. Similarly, although FIG. 6 illustrates an example in which n-number of column lines B are provided, any number of column lines B may be provided. Further, in the example embodiment illustrated in FIG. 6, a set of one switch SW, one capacitor CP, and one operational amplifier OP may be provided for the n-number of column lines B; however, two or more sets of one switch SW, one capacitor CP, and one operational amplifier OP may be provided for the n-number of column lines B.

[Column Line Selector SB]

The column line selector SB may include switches SWB1 (SWB1-1 to SWB1-n) and switches SWB2 (SWB2-1 to SWB2-n). The switches SWB1 (SWB1-1 to SWB1-n) and the switches SWB2 (SWB2-1 to SWB2-n) may each be switchable between the conducting state and the nonconducting state. The switches SWB1 (SWB1-1 to SWB1-n) may each be provided between corresponding one of the column lines B (B1 to Bn) and the negative input terminal T2 of the operational amplifier OP. The switches SWB2 (SWB2-1 to SWB2-n) may each be provided between corresponding one of the column lines B (B1 to Bn) and the direct-current power supply PS2.

The column line selector SB may select one column line B, which will be referred to as a selected column line BS for convenience, from among the plurality of column lines B, and may couple the selected column line BS to the negative input terminal T2 of the operational amplifier OP. The column line selector SB may further couple the column lines B other than the selected column line BS, which will be referred to as unselected column lines BU for convenience, to the direct-current power supply PS2 via the switches SWB2 (SWB2-1 to SWB2-n). Operation of the column line selector SB may be controlled by the processor CTRL. For example, a switching operation of the column line selector SB on each of the switches SWB1 (SWB1-1 to SWB1-n) and each of the switches SWB2 (SWB2-1 to SWB2-n) may be executed based on a command from the processor CTRL.

[Measurement Operation in Element Array Circuit 3]

In the element array circuit 3, it is possible to perform measurement on each of the resistors R in the following manner, for example. The following measurement operation may be performed in accordance with a command from the processor CTRL.

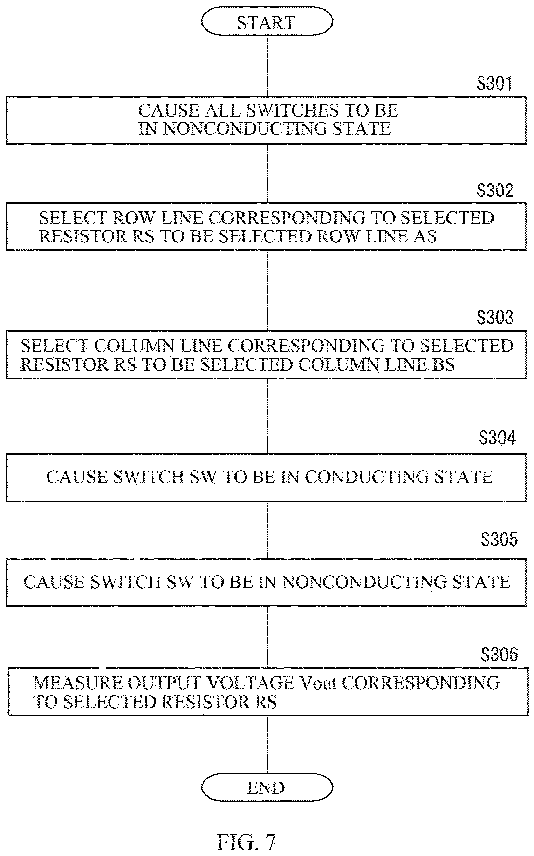

FIG. 7 is a flowchart describing an example measurement operation of the element array circuit 3. First, all the switches may be caused to be in the nonconducting state (step S301). For example, the switch SW, the switches SWA1 (SWA1-1 to SWA1-m), the switches SWA2 (SWA2-1 to SWA2-m), the switches SWB1 (SWB1-1 to SWB1-n), and the switches SWB2 (SWB2-1 to SWB2-n) illustrated in FIG. 6 may all be caused to be in the nonconducting state, i.e., the open state.

Thereafter, one row line corresponding to the selected resistor RS targeted for the measurement may be selected to be the selected row line AS (step S302). This step S302 may be performed in a manner similar to that for step S102 of FIG. 2 described in relation to the foregoing first example embodiment.

Thereafter, one column line corresponding to the selected resistor RS targeted for the measurement may be selected to be the selected column line BS (step S303). For example, the switch SWB1 coupled to the selected column line BS to which the selected resistor RS is coupled may be caused to be in the conducting state to thereby couple the selected column line BS to the operational amplifier OP. The other switches SWB1 corresponding to the unselected column lines BU may be kept in the nonconducting state. Further, the switches SWB2 of the unselected column lines BU may be caused to be in the conducting state to thereby cause the second voltage V2 to be applied to the unselected column lines BU. The switch SWB2 corresponding to the selected column line BS may be kept in the nonconducting state. FIG. 6 illustrates an example state where the resistor R(1, 1) is selected as the selected resistor RS. In this case, the switch SWB1-1 corresponding to the column line B1 as the selected column line BS may be caused to be in the conducting state to thereby cause the column line B1 to be electrically continuous with the operational amplifier OP. The switches SWB1-2 to SWB1-n corresponding to the column lines B2 to Bn as the unselected column lines BU may be kept in the nonconducting state. Further, the switches SWB2-2 to SWB2-n corresponding to the column lines B2 to Bn as the unselected column lines BU may be caused to be in the conducting state to thereby cause the second voltage V2 to be applied to the column lines B2 to Bn. The switch SWB2-1 corresponding to the column line B1 as the selected column line BS may be kept in the nonconducting state.

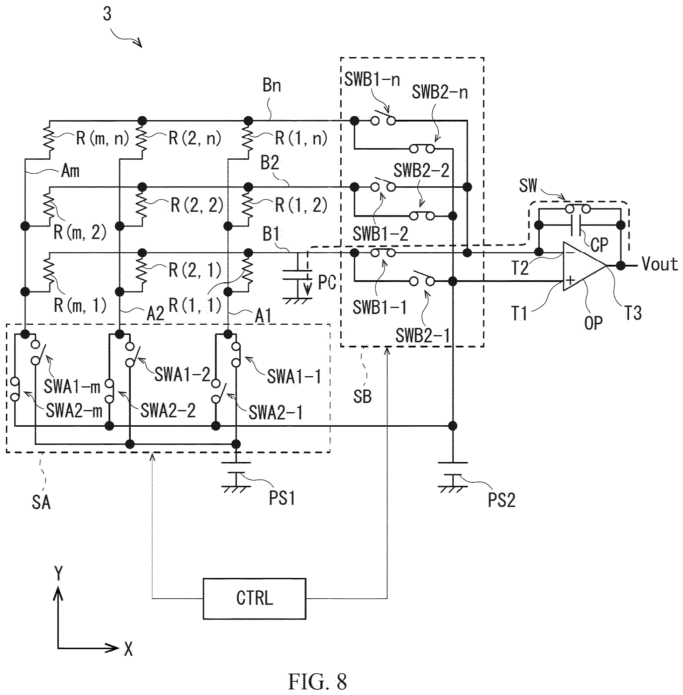

Thereafter, the switch SW may be caused to be in the conducting state (step S304) to allow for charging of the parasitic capacitance parasitic to the selected column line BS corresponding to the selected resistor RS targeted for the measurement. For example, while causing the switch SWB1-1 corresponding to the column line B1 as the selected column line BS to be in the conducting state, the switch SW may be caused to be in the conducting state to thereby establish electrical continuity between the column line B1 and the output terminal T3 of the operational amplifier OP. FIG. 8 illustrates a circuit diagram describing a charging operation on the parasitic capacitance PC in the element array circuit 3. As indicated in a broken-line arrow in FIG. 8, causing the switch SW to be in the conducting state allows a current to flow through the column line B1 from the operational amplifier OP, thus allowing for charging of the parasitic capacitance PC parasitic to the column line B1. Here, the parasitic capacitance PC of the selected column line BS may be charged by causing the switch SW to be in the conducting state over a period of time longer than a period of time that allows electric charge of the capacitor CP to be discharged almost completely. For example, the parasitic capacitance PC of the selected column line BS may be charged by causing the switch SW to be in the conducting state over a period of time longer than five times the product of the capacitance value of the capacitor CP and the resistance value of the switch SW, that is, five times the time constant. Causing the switch SW to be in the conducting state over a period of time as long as five times the product of the capacitance value of the capacitor CP and the resistance value of the switch SW allows 99.3% of the electric charge of the capacitor CP to be discharged. Further, the parasitic capacitance PC of the selected column line BS may be charged by causing the switch SW to be in the conducting state over a period of time longer than five times the product of the capacitance value of the parasitic capacitance PC of the selected column line BS and a sum of the resistance value of the switch SW and the resistance value of the switch SWB corresponding to the selected column line BS when the switch SWB is in the conducting state. One reason for this is that such a length of time allows the parasitic capacitance PC of the selected column line BS to be sufficiently charged and thus allows for accurate measurement of the output voltage Vout resulting from the selected resistor RS.

Thereafter, the switch SW may be caused to be in the nonconducting state (step S305). This may end the charging of the parasitic capacitance PC of the selected column line BS that has been performed by causing the switch SW to be in the conducting state. At this time, the difference voltage between the first voltage V1 and the second voltage V2, i.e., V2 - V1, may be applied to the resistor R(1, 1), and a current dependent on the resistance value of the resistor R(1, 1) may flow through the resistor R(1, 1) and through the column line B1 as the selected column line BS toward the capacitor CP. In contrast, the second voltage V2 may be applied to the row lines A2 to Am other than the row line A1 as the selected row line AS, and to the column line B1. Accordingly, the voltage to be applied to the resistors R other than the resistor R(1, 1) as the selected resistor RS, among the resistors R(1, 1) to R(1, m) coupled to the column line B1 as the selected column line BS, may be zero, resulting in no current flowing through the resistors R(1, 2) to R(1, m). Further, because the resistors R coupled to the column lines B2 to Bn as the unselected column lines BU are not coupled to the capacitor CP, those resistors R will not affect the capacitor CP.

Thereafter, the output voltage corresponding to the selected resistor RS may be measured (step S306). This step S306 may be performed in a manner similar to that for step S105 of FIG. 2 described in relation to the foregoing first example embodiment. Note that in step S306, the output voltage Vout outputted from the output terminal T3 of the operational amplifier OP may be measured. As described in relation to the foregoing first example embodiment, the resistance value rs of the selected resistor RS is calculable from the output voltage Vout outputted from the output terminal T3 of the operational amplifier OP, based on Expression (1). It is to be noted that in the present example embodiment, in Expression (1), "cs [F]" shall represent the capacitance value of the capacitor CP; "rs [Ω]" shall represent the resistance value of one selected resistor RS corresponding to the selected column line BS; "T [sec.]" shall represent an elapsed period of time after the switch SW is caused to be in the nonconducting state; and "Vout [V]" shall represent an output voltage of the operational amplifier OP after a lapse of T [sec.].

The measurement operation in the element array circuit 3 may thus be completed. When measuring the output voltage Vout corresponding to any of the resistors R other than the resistor R(1, 1), steps S301 to S306 described above may be repeated. However, for the column line B to which the resistor R having undergone the measurement is coupled, the operation of charging the parasitic capacitance thereof again may be omitted. In the example embodiment illustrated in FIG. 6, the unselected column lines BU may have respective first ends coupled to the direct-current power supply PS2 via the switches SWB2. Accordingly, the parasitic capacitances of the unselected column lines BU are chargeable with a current from the direct-current power supply PS2 to some extent. However, a slight error, i.e., an offset voltage, can develop between the second voltage V2 applied from the direct-current power supply PS2 and the potential at the negative input terminal T2, and the error can result in insufficient charging of the parasitic capacitance of the unselected column lines BU with the current from the direct-current power supply PS2. To increase accuracy of measurement, the operation of charging the parasitic capacitance of the selected column line BS by causing the switch SW to be in the conducting state may thus be performed at each selection of any of the column lines BS to be the selected column line BS. Further, in the present example embodiment, the order of steps S302 to S305 may be changed to any desired order, provided that step S303 precedes step S305 and that step S304 precedes step S305. For example, possible orders of steps S302 to S305 include the following: (a) S302, S304, S303, and then S305; (b) S303, S302, S304, and then S305; (c) S303, S304, S302, and then S305; (d) S303, S304, S305, and then S302; (e) S304, S302, S303, and then S305; (f) S304, S303, S302, and then S305; and (g) S304, S303, S305, and then S302. When step S304 precedes step S303, charging of the parasitic capacitance PC of any of the column lines B selected as the selected column line BS may start at a point when the switch SWB1 corresponding to the column line B to be the selected column line BS is caused to be in the conducting state with the switch SW caused to be in the conducting state. Further, although FIG. 6 illustrates an example in which the respective first ends of the unselected column lines BU may be coupled to the direct-current power supply PS2 via the switches SWB2, the destination of coupling of the respective first ends of the unselected column lines BU is not limited as long as none of the unselected column lines BU is coupled to the capacitor CP and accordingly no current is to flow between any of the unselected column lines BU and the capacitor CP.

[Example Workings and Example Effects of Element Array Circuit 3]

The element array circuit 3 according to the third example embodiment is expected to provide effects similar to those of the element array circuit 1 according to the foregoing first example embodiment. For example, the element array circuit 3 according to the third example embodiment is provided with the switch SW, which allows for quick charging of the parasitic capacitance parasitic to the selected column line BS. This helps to bring the output voltage Vout resulting from the selected resistor RS coupled to the selected column line BS into a steady state quickly, thus allowing for quick and accurate measurement of the output voltage Vout related to the resistance value of the selected resistor RS.
Moreover, in the element array circuit 3 according to the third example embodiment, any of the column lines B is selectively couplable to the single operational amplifier OP through the use of the column line selector SB. This helps to achieve further downsizing of the circuit as compared with the element array circuit 1 of the foregoing first example embodiment that includes the plurality of operational amplifiers OP.

[4. Fourth Example Embodiment]

[Overall Configuration Example of Element Array Circuit 4]

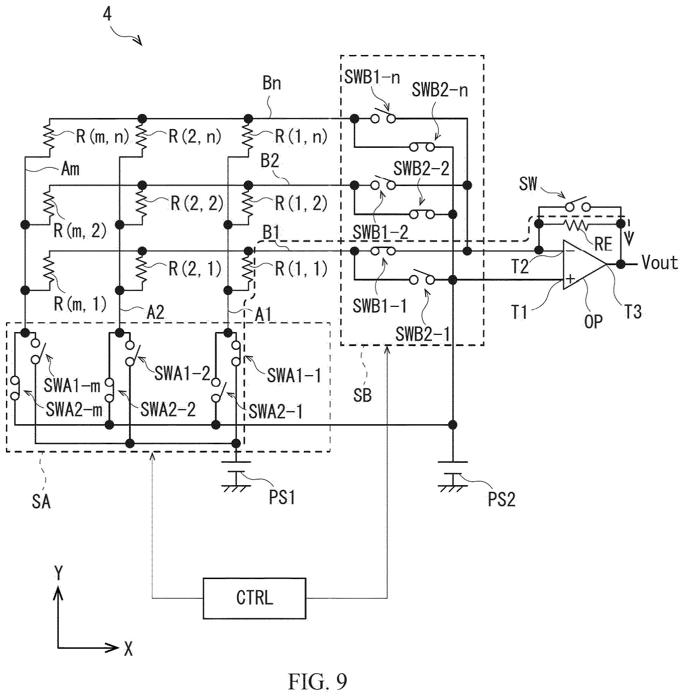

FIG. 9 is a circuit diagram schematically illustrating a configuration example of an element array circuit 4 according to a fourth example embodiment of the disclosure. As illustrated in FIG. 9, the element array circuit 4 may have a configuration substantially the same as that of the element array circuit 3 of the third example embodiment illustrated in FIG. 6, except for including a single resistor RE, instead of the single capacitor CP, as a single conversion element. It is to be noted that although FIG. 9 illustrates an example in which m-number of row lines A are provided, any number of row lines A may be provided. Similarly, although FIG. 9 illustrates an example in which n-number of column lines B are provided, any number of column lines B may be provided. Further, in the example embodiment illustrated in FIG. 9, a set of one switch SW, one resistor RE, and one operational amplifier OP may be provided for the n-number of column lines B; however, two or more sets of one switch SW, one resistor RE, and one operational amplifier OP may be provided for the n-number of column lines B.
The measurement operation of the element array circuit 4 according to the present example embodiment may also be performed in accordance with the procedure described with reference to FIG. 7 in the third example embodiment, that is, by carrying out steps S301 to S306. As with the third example embodiment, the period of time over which the parasitic capacitance PC of the selected column line BS is charged by causing the switch SW to be in the conducting state may be longer than five times the product of the capacitance value of the parasitic capacitance PC and the sum of the resistance value of the switch SW and the resistance value of the switch SWB corresponding to the selected column line BS. Further, in step S306, the output voltage Vout outputted from the output terminal T3 of the operational amplifier OP may be measured. As described in relation to the second example embodiment, the resistance value rs of the selected resistor RS is calculable from the output voltage Vout outputted from the output terminal T3 of the operational amplifier OP, based on Expression (2). It is to be noted that in the present example embodiment, in Expression (2), "re [$\Omega$]" shall represent the resistance value of the resistor RE; "rs [$\Omega$]" shall represent the resistance value of one selected resistor RS corresponding to the selected column line BS; and "Vout [V]" shall represent the output voltage of the operational amplifier OP.

[Example Workings and Example Effects of Element Array Circuit 4]

The element array circuit 4 according to the fourth example embodiment is expected to provide effects similar to those of the element array circuit 3 according to the foregoing third example embodiment. For example, the element array circuit 4 according to the fourth example embodiment is provided with the switch SW, which allows for quick charging of the parasitic capacitance parasitic to the selected column line BS. This helps to bring the output voltage Vout resulting from the selected resistor RS coupled to the selected column line BS into the steady state quickly, thus allowing for quick and accurate measurement of the output voltage Vout related to the resistance value of the selected resistor RS.

Moreover, in the element array circuit 4 according to the fourth example embodiment, any of the column lines B is selectively couplable to the single operational amplifier OP through the use of the column line selector SB. This helps to achieve further downsizing of the circuit as compared with the element array circuit 2 of the foregoing second example embodiment that includes the plurality of operational amplifiers OP.

[5. Fifth Example Embodiment]

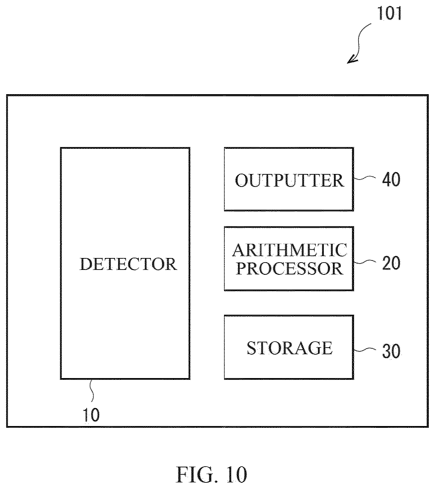

FIG. 10 schematically illustrates a configuration example of a sensor device 101 including the element array circuit according to one embodiment of the disclosure. As illustrated in FIG. 10, the sensor device 101 may include a detector 10, an arithmetic processor 20, a storage 30, and an outputter 40. Examples of the sensor device 101 may include an electromagnetic wave sensor that detects an intensity of a received electromagnetic wave. Note that the configuration of the sensor device 101 illustrated in FIG. 10 is one example, and possible configurations of the sensor device 101 are not limited thereto.

The detector 10 may include at least one of the element array circuit 1, 2, 3, or 4 described in the first, second, third, or fourth example embodiment above. Examples of the detector 10 may include an infrared detector that receives infrared rays and outputs a voltage that changes with the intensity of the received infrared rays. Alternatively, the detector 10 may receive an electromagnetic wave other than infrared rays, such as a terahertz wave, and may output a voltage that changes with the intensity of the received electromagnetic wave.

The arithmetic processor 20 may receive an output voltage from the detector 10 and perform arithmetic processing thereon, such as converting the output voltage into data of a desired parameter. The storage 30 may hold the data generated at the arithmetic processor 20. The outputter 40 may output the data generated at the arithmetic processor 20 to an external apparatus as an electric signal.

The sensor device 101 according to the present example embodiment may be provided with the detector 10 including at least one of the element array circuit 1, 2, 3, or 4. This allows for quick and accurate measurement of the intensity of the received electromagnetic wave.

Note that the description is given above of an example case in which the resistors R in the detector 10 may each be a light receiving element that converts an electromagnetic wave such as infrared rays into an electric signal; however, the sensor device 101 according to the present example embodiment is not limited to such a kind of device.

For example, as the resistor R of the element array circuit 1, 2, 3, or 4 in the detector 10, a temperature-sensitive resistor element including, for example, a thermistor material or a temperature-sensitive electrically-conductive ink material may be employed. Such a temperature-sensitive resistor element may change in electrical resistance value with changing temperature. In such a case, the sensor device 101 may serve as a temperature sensor configured to detect a temperature distribution in a plane.

Alternatively, as the resistor R of the element array circuit 1, 2, 3, or 4 in the detector 10, a pressure-sensitive element including, for example, a pressure-sensitive electrically-conductive ink material may be employed. Such a pressure-sensitive element may change in electrical resistance value with changing magnitude of an applied pressure. The sensor device 101 with the detector 10 including the pressure-sensitive elements as the resistors R may serve as a pressure sensor configured to detect a pressure distribution in a plane.

Alternatively, as the resistor R of the element array circuit 1, 2, 3, or 4 in the detector 10, a strain gauge may be employed. The strain gauge may change in electrical resistance value with changing magnitude of an applied stress. The sensor device 101 with the detector 10 including the strain gauges as the resistors R may serve as a strain sensor configured to detect a stress distribution in a plane.

[6. Modification Examples]

Although some example embodiments of the disclosure have been described hereinabove, the disclosure is not limited to such example embodiments, and may be modified in a variety of ways.

For example, although respective illustrations of the element array circuits 1 to 4 of the foregoing first to fourth example embodiments in the drawings each exemplify a case in which the row lines extend in parallel to each other, embodiments of the disclosure are not limited thereto. In some embodiments, the row lines may be non-parallel to each other. Further, each of the row lines does not have to extend linearly, and may extend in a curved shape as a whole, or may be shaped to include a curved portion or a bent portion. Similarly, although the respective illustrations of the element array circuits 1 to 4 of the first to fourth example embodiments in the drawings each exemplify a case in which the column lines extend in parallel to each other, embodiments of the disclosure are not limited thereto. In some embodiments, the column lines may be non-parallel to each other. Further, embodiments of the disclosure are not limited to a case in which the row lines and the column lines extend in directions orthogonal to each other. Moreover, each of the column lines does not have to extend linearly, and may extend in a curved shape as a whole, or may be shaped to include a curved portion or a bent portion.

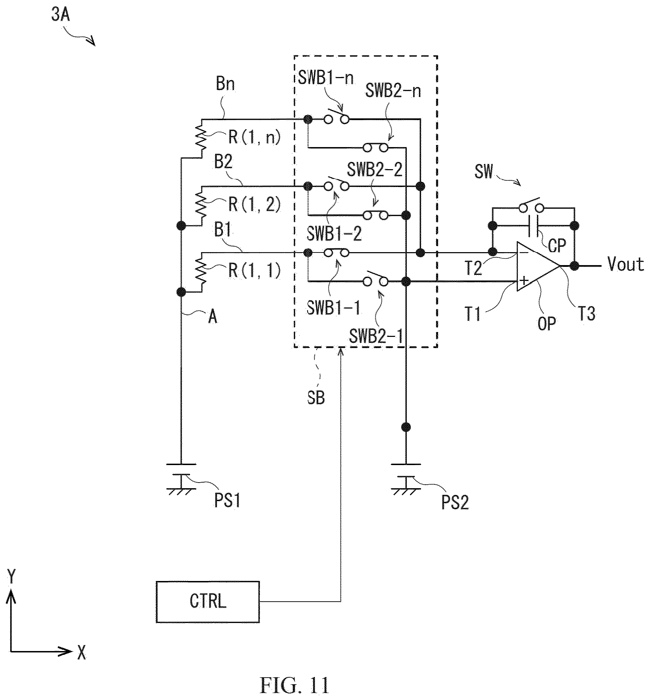

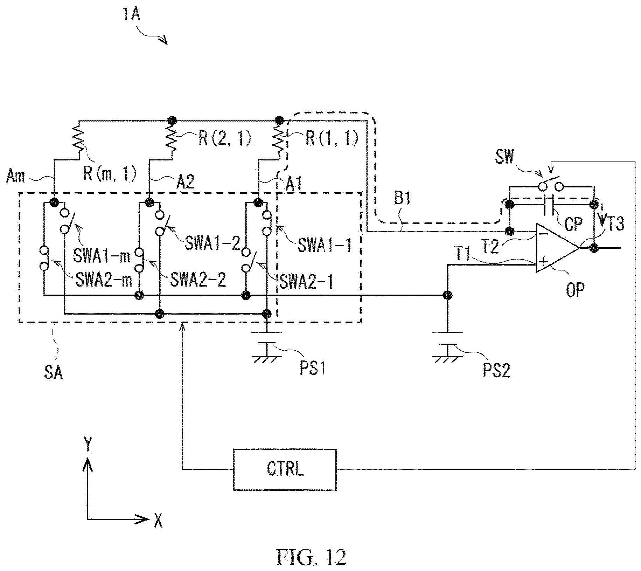

The element array circuits 1 to 4 of the foregoing first to fourth example embodiments may each include a plurality of row lines and a plurality of column lines; however, embodiments of the disclosure are not limited thereto. For example, an element array circuit 3A illustrated in FIG. 11 may include a single row line A. The element array circuit 3A may have a configuration substantially the same as the configuration of the element array circuit 3 illustrated in FIG. 8, except that the single row line A is provided instead of the row lines A1 to Am and that the row line selector SAis not provided. Further, an element array circuit 1Aillustrated in FIG. 12 may include a single column line B. The element array circuit 1A may have a configuration substantially the same as the configuration of the element array circuit 1, except that the single column line B is provided instead of the column lines B1 to Bn.

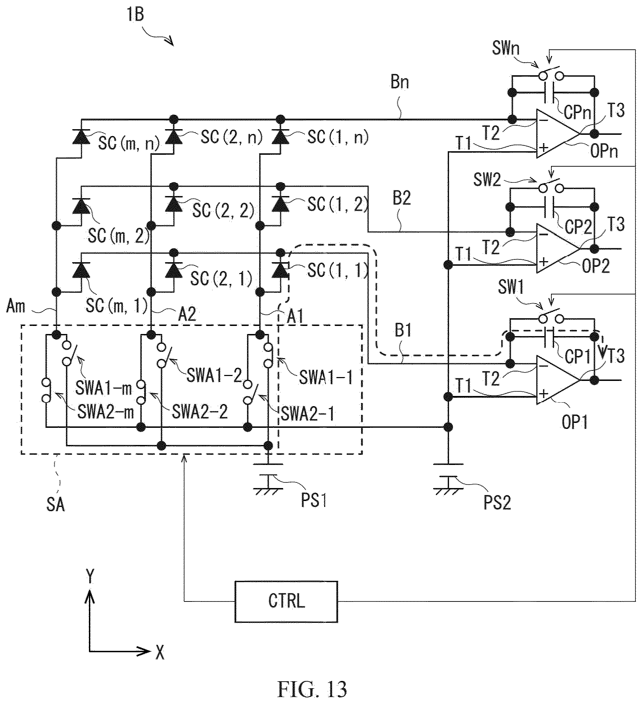

The element array circuits 1 to 4 of the foregoing first to fourth example embodiments may each include the plurality of resistors R as a plurality of impedance elements; however, embodiments of the disclosure are not limited thereto. For example, an element array circuit 1B illustrated in FIG. 13 may include a plurality of semiconductor elements SC. The element array circuit 1B may have a configuration substantially the same as the configuration of the element array circuit 1, except that the semiconductor elements SC are provided instead of the resistors R. The semiconductor element SC may have an electrical property that changes with temperature. Examples of the semiconductor element SC may include a diode. For example, the thermistor film described as an example of the resistor R in the first example embodiment may be replaced with a diode whose impedance value changes with temperature, and the temperature of the diode may be detected as an output voltage resulting from the impedance value of the diode. Such an element array circuit may be applied to an electromagnetic wave sensor that detects the intensity of an electromagnetic wave such as infrared rays, or to a temperature sensor configured to detect a temperature distribution in a plane.

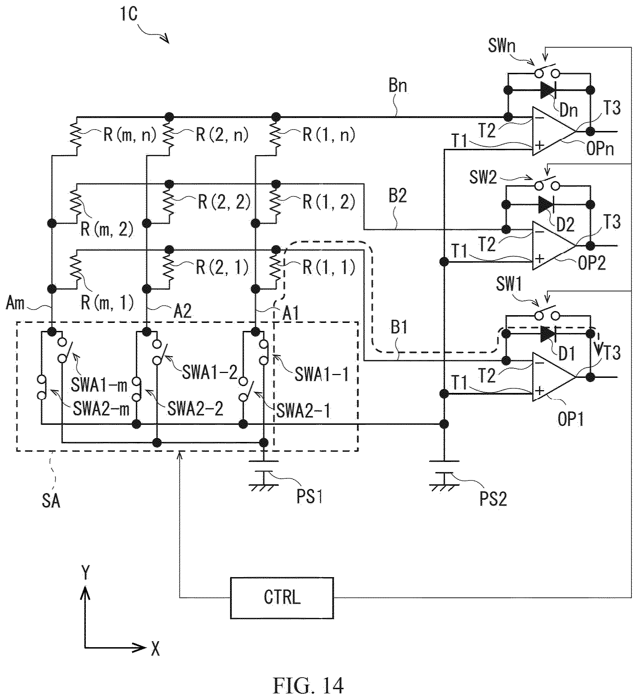

Further, although the element array circuits 1 to 4 of the foregoing first to fourth example embodiments may each include the one or more capacitors CP or the one or more resistors RE as one or more conversion elements, embodiments of the disclosure are not limited thereto. In some embodiments, one or more semiconductor elements may be employed, for example. As in an element array circuit 1C illustrated in FIG. 14, for example, a plurality of diodes D may be provided as a plurality of conversion elements. In an embodiment illustrated in FIG. 14, currents dependent on the respective resistance values of the resistors R(1, 1) to R(1, n) may flow through the respective resistors R(1, 1) to R(1, n), through the respective column lines B1 to Bn, and through respective diodes D1 to Dn. The currents flowing through the respective column lines B1 to Bn may be converted by the respective diodes D1 to Dn into voltages in accordance with respective current-voltage characteristics of the diodes D1 to Dn, and may be outputted as the output voltages Vout from the output terminals T3 of the operational amplifiers OP1 to OPn corresponding to the respective resistors R(1, 1) to R(1, n).

In the element array circuit according to at least one embodiment of the disclosure, charging of the parasitic capacitance parasitic to the second wiring line coupled to the negative input terminal of the operational amplifier is performed quickly by causing the switcher into the conducting state to thereby establish electrical continuity between: the second wiring line coupled to the negative input terminal; and the output terminal of the operational amplifier. It is possible to measure the output voltage resulting from the impedance element and outputted from the output terminal, upon switching the switcher into the nonconducting state after the charging.

The element array circuit, the electromagnetic wave sensor, the temperature sensor, and the strain sensor according to at least one embodiment of the disclosure each provide a measured value quickly with high accuracy.

The effects described herein are mere examples and non-limiting, and other effects may be achieved.

Although the disclosure has been described hereinabove in terms of the example embodiment and modification examples, the disclosure is not limited thereto. It should be appreciated that variations may be made in the described example embodiment and modification examples by those skilled in the art without departing from the scope of the disclosure as defined by the following claims. The limitations in the claims are to be interpreted broadly based on the language employed in the claims and not limited to examples described in this specification or during the prosecution of the application, and the examples are to be construed as non-exclusive. The use of the terms first, second, etc. do not denote any order or importance, but rather the terms first, second, etc. are used to distinguish one element from another. The term "substantially" and its variants are defined as being largely but not necessarily wholly what is specified as understood by one of ordinary skill in the art. The term "disposed on/ provided on/ formed on" and its variants as used herein refer to elements disposed directly in contact with each other or indirectly by having intervening structures therebetween. Moreover, no element or component in this disclosure is intended to be dedicated to the public regardless of whether the element or component is explicitly recited in the following claims.

**Claims**

1. An element array circuit (1; 1B; 1C; 2; 3; 3A; 4) comprising:

   one or more first wiring lines (A; A1, ..., Am);
   a plurality of second wiring lines (B; B1, ..., Bn), the second wiring lines (B; B1, ..., Bn) each extending in a direction different from a direction in which the one or more first wiring lines (A; A1, ..., Am) each extend;
   a plurality of impedance elements (R; R(1, 1), ..., R(m, n); SC; SC(1, 1), ..., SC(m, n)), the impedance elements (R; R(1, 1), ..., R(m, n); SC; SC(1, 1), ..., SC(m, n)) each being coupled to both one of the one or more first wiring lines (A; A1, ..., Am) and one of the second wiring lines (B; B1, ..., Bn);
   one or more operational amplifiers (OP; OP1, ..., OPn) each including a positive input terminal (T1), a negative input terminal (T2), and an output terminal (T3), the negative input terminal (T2) being couplable to one of the second wiring lines (B; B1, ..., Bn); and
   one or more conversion elements (CP; CP1, ...., CPn; RE; RE1, ..., REn; D; D1, ..., Dn) each coupled to the negative input terminal (T2) and the output terminal (T3) of corresponding one of the one or more operational amplifiers (OP; OP1, ..., OPn), and each configured to convert a current flowing through one of the second wiring lines (B; B1, ..., Bn) that is coupled to the negative input terminal (T2) into a voltage;
   **characterized in that**
   the element array circuit (1; 1B; 1C; 2; 3; 3A; 4) further comprises:
   one or more switchers (SW; SW1, ..., SWn) each coupled to one of the one or more conversion elements (CP; CP1, ...., CPn; RE; RE1, ..., REn; D; D1, ..., Dn) in parallel between the negative input terminal (T2) and the output terminal (T3) of corresponding one of the one or more operational amplifiers (OP; OP1, ..., OPn), and each configured to come into either a conducting state or a nonconducting state.

2. The element array circuit (1; 1B; 1C; 2; 3; 3A; 4) according to claim 1, further comprising a processor (CTRL) configured to execute a control of: performing charging of a parasitic capacitance (PC) parasitic to one of the second wiring lines (B; B1, ..., Bn) that is coupled to the negative input terminal (T2) of corresponding one of the one or more operational amplifiers (OP; OP1, ..., OPn); and switching, after performing the charging, one of the one or more switchers (SW; SW1, ..., SWn) that corresponds to the negative input terminal (T2) into the nonconducting state, wherein
   in executing the control, the processor (CTRL) is configured to perform the charging of the parasitic capacitance (PC) by causing the one of the one or more switchers (SW; SW1, ..., SWn) that corresponds to the negative input terminal (T2) to be in the conducting state and by establishing electrical continuity between: the one of the second wiring lines (B; B1, ..., Bn) that is coupled to the negative input terminal (T2); and the output terminal (T3).

3. The element array circuit (1; 1B; 1C; 2; 3; 3A; 4) according to claim 2, wherein the processor (CTRL) is configured to, after performing the charging of the parasitic capacitance (PC), switch the one of the one or more switchers (SW; SW1, ..., SWn) that corresponds to the negative input terminal (T2) into the nonconducting state, and to measure, after switching the one of the one or more switchers (SW; SW1, ..., SWn), an output voltage (Vout) outputted from the output terminal (T3), the output voltage (Vout) resulting from one of the impedance elements (R; R(1, 1), ..., R(m, n); SC; SC(1, 1), ..., SC(m, n)) that is coupled to both relevant one of the one or more first wiring lines (A; A1, ..., Am) and the one of the second wiring lines (B; B1, ..., Bn) that is coupled to the negative input terminal (T2).

4. The element array circuit (3; 3A; 4) according to claim 1, further comprising a selector (SB) configured to select one of the second wiring lines (B; B1, ..., Bn) and to couple the one of the second wiring lines (B; B1, ..., Bn) selected to the negative input terminal (T2).

5. The element array circuit (3; 3A; 4) according to claim 4, further comprising a processor (CTRL) configured to execute a control of: performing charging of a parasitic capacitance (PC) parasitic to one of the second wiring lines (B; B1, ...,

17

Bn) that is coupled to the negative input terminal (T2) of corresponding one of the one or more operational amplifiers (OP; OP1, ..., OPn); and switching, after performing the charging, one of the one or more switchers (SW; SW1, ..., SWn) that corresponds to the negative input terminal (T2) into the nonconducting state, wherein

in executing the control, the processor (CTRL) is configured to perform the charging of the parasitic capacitance (PC) by causing the one of the one or more switchers (SW; SW1, ..., SWn) that corresponds to the negative input terminal (T2) to be in the conducting state and by establishing electrical continuity between: the one of the second wiring lines (B; B1, ..., Bn) that is coupled to the negative input terminal (T2); and the output terminal (T3), and a period of time over which the charging of the parasitic capacitance (PC) is to be performed by causing the one of the one or more switchers (SW; SW1, ..., SWn) to be in the conducting state is longer than five times a product of a capacitance value of the parasitic capacitance (PC) and a sum of a resistance value of the one of the one or more switchers (SW; SW1, ..., SWn) and a resistance value of the selector (SB).

6. The element array circuit (1; 1B; 1C; 2; 3; 3A; 4) according to claim 1, wherein

the one or more operational amplifiers (OP; OP1, ..., OPn) comprise a plurality of the operational amplifiers (OP; OP1, ..., OPn),
the one or more switchers (SW; SW1, ..., SWn) comprise a plurality of the switchers (SW; SW1, ..., SWn),
the one or more conversion elements (CP; CP1, ...., CPn; RE; RE1, ..., REn; D; D1, ..., Dn) comprise a plurality of the conversion elements (CP; CP1, ...., CPn; RE; RE1, ..., REn; D; D1, ..., Dn),
the operational amplifiers (OP; OP1, ..., OPn) are each coupled to corresponding one of the second wiring lines (B; B1, ..., Bn),
the switchers (SW; SW1, ..., SWn) are each coupled to corresponding one of the operational amplifiers (OP; OP1, ..., OPn), and
the conversion elements (CP; CP1, ...., CPn; RE; RE1, ..., REn; D; D1, ..., Dn) are each coupled to corresponding one of the operational amplifiers (OP; OP1, ..., OPn).

7. The element array circuit (1; 1B; 1C; 2; 3; 3A; 4) according to claim 6, further comprising a processor (CTRL) configured to execute a control of: performing charging of a parasitic capacitance (PC) parasitic to one of the second wiring lines (B; B1, ..., Bn) that is coupled to the negative input terminal (T2) of corresponding one of the operational amplifiers (OP; OP1, ..., OPn); and switching, after performing the charging, one of the switchers (SW; SW1, ..., SWn) that corresponds to the negative input terminal (T2) into the nonconducting state, wherein

in executing the control, the processor (CTRL) is configured to perform the charging of the parasitic capacitance (PC) by causing the one of the switchers (SW; SW1, ..., SWn) that corresponds to the negative input terminal (T2) to be in the conducting state and by establishing electrical continuity between: the one of the second wiring lines (B; B1, ..., Bn) that is coupled to the negative input terminal (T2); and the output terminal (T3), and a period of time over which the charging of the parasitic capacitance (PC) is to be performed by causing the one of the switchers (SW; SW1, ..., SWn) that corresponds to the negative input terminal (T2) to be in the conducting state is longer than five times a product of a capacitance value of the parasitic capacitance (PC) and a resistance value of the one of the switchers (SW; SW1, ..., SWn).

8. The element array circuit (1; 1B; 1C; 2; 3; 4) according to claim 1, wherein

the one or more first wiring lines (A; A1, ..., An) comprise a plurality of the first wiring lines (A; A1, ..., An), and
the impedance elements (R; R(1, 1), ..., R(m, n); SC; SC(1, 1), ..., SC(m, n)) are each coupled to both one of the first wiring lines (A; A1, ..., An) and one of the second wiring lines (B; B1, ..., Bn).

9. The element array circuit (1; 1A; 1B; 3; 3A) according to claim 2, wherein

the one or more conversion elements (CP; CP1, ...., CPn; RE; RE1, ..., REn; D; D1, ..., Dn) comprise one or more capacitors (CP; CP1, ..., CPn), and
a period of time over which the charging of the parasitic capacitance (PC) is to be performed by causing the one of the one or more switchers (SW; SW1, ..., SWn) that corresponds to the negative input terminal (T2) to be in the conducting state is longer than five times a product of a capacitance value of one of the one or more capacitors (CP; CP1, ..., CPn) that corresponds to the negative input terminal (T2) and a resistance value of the one of the one or more switchers (SW; SW1, ..., SWn) that corresponds to the negative input terminal (T2).

10. The element array circuit (1; 1A; 1B; 1C; 2; 3; 3A; 4) according to claim 1, wherein each of the one or more conversion elements (CP; CP1, ...., CPn; RE; RE1, ..., REn; D; D1, ..., Dn) comprises a capacitor (CP), a resistor (RE), or a semiconductor element (D).

11. The element array circuit (1; 1A; 1B; 1C; 2; 3; 3A; 4) according to claim 1, wherein each of the impedance elements (R; R(1, 1), ..., R(m, n); SC; SC(1, 1), ..., SC(m, n)) comprises a resistor (R) or a semiconductor element (SC).

12. An electromagnetic wave sensor (101) comprising the element array circuit (1; 1B; 1C; 2; 3; 3A; 4) according to claim 1.

13. A temperature sensor (101) comprising the element array circuit (1; 1B; 1C; 2; 3; 3A; 4) according to claim 1.

14. A strain sensor (101) comprising the element array circuit (1; 1B; 1C; 2; 3; 3A; 4) according to claim 1.


**Patentansprüche**

1. Eine Element-Array-Schaltung (1; 1B; 1C; 2; 3; 3A; 4), umfassend:

   eine oder mehrere erste Verdrahtungsleitungen (A; A1, ..., Am);
   eine Mehrzahl von zweiten Verdrahtungsleitungen (B; B1, ..., Bn), wobei sich die zweiten Verdrahtungsleitungen (B; B1, ..., Bn) jeweils in einer Richtung erstrecken, die sich von einer Richtung unterscheidet, in der sich die eine oder mehreren ersten Verdrahtungsleitungen (A; A1, ..., Am) jeweils erstrecken;
   eine Mehrzahl von Impedanzelementen ( R; R(1, 1), ..., R(m, n); SC; SC(1, 1), ..., SC(m, n)), wobei die Impedanzelemente (R; R(1, 1), ..., R(m, n); SC; SC(1, 1), ..., SC(m, n)) jeweils sowohl mit einer der einen oder mehreren ersten Verdrahtungsleitungen (A; A1, ..., Am) als auch mit einer der zweiten Verdrahtungsleitungen (B; B1, ..., Bn) gekoppelt sind;
   einen oder mehrere Operationsverstärker (OP; OP1, ..., OPn), die jeweils einen positiven Eingangsanschluss (T1), einen negativen Eingangsanschluss (T2) und einen Ausgangsanschluss (T3) aufweisen, wobei der negative Eingangsanschluss (T2) mit einer der zweiten Verdrahtungsleitungen (B; B1, ..., Bn) koppelbar ist; und
   ein oder mehrere Umwandlungselemente (CP; CP1, ...., CPn; RE; RE1, ..., REn; D; D1, ..., Dn), die jeweils mit dem negativen Eingangsanschluss (T2) und dem Ausgangsanschluss (T3) eines entsprechenden des einen oder der mehreren Operationsverstärker (OP; OP1, ..., OPn) gekoppelt sind und jeweils dazu eingerichtet sind, einen Strom, der durch eine der zweiten Verdrahtungsleitungen (B; B1, ..., Bn) fließt, die mit dem negativen Eingangsanschluss (T2) gekoppelt ist, in eine Spannung umzuwandeln
   **dadurch gekennzeichnet, dass**
   die Element-Array-Schaltung (1; 1B; 1C; 2; 3; 3A; 4) ferner umfasst:
   einen oder mehrere Schalter (SW; SW1, ..., SWn), die jeweils mit einem des einen oder der mehreren Umwandlungselemente (CP; CP1, ...., CPn; RE; RE1, ..., REn; D; D1, ..., Dn) parallel gekoppelt sind, zwischen dem negativen Eingangsanschluss (T2) und dem Ausgangsanschluss (T3) eines entsprechenden des einen oder der mehreren Operationsverstärker (OP; OP1, ..., OPn), und jeweils dazu eingerichtet sind, entweder in einen leitenden Zustand oder in einen nichtleitenden Zustand zu gelangen.

2. Die Element-Array-Schaltung (1; 1B; 1C; 2; 3; 3A; 4) gemäß Anspruch 1, die ferner einen Prozessor (CTRL) umfasst, der dazu eingerichtet ist, eine Steuerung auszuführen zum: Durchführen eines Ladens einer parasitären Kapazität (PC), die parasitär zu einer der zweiten Verdrahtungsleitungen (B; B1, ..., Bn) ist, die mit dem negativen Eingangsanschluss (T2) eines entsprechenden des einen oder der mehreren Operationsverstärker (OP; OP1, ..., OPn) gekoppelt ist; und Schalten, nach dem Durchführen des Ladens, eines des einen oder der mehreren Schalter (SW; SW1, ..., SWn), der zu dem negativen Eingangsanschluss (T2) korrespondiert, in den nichtleitenden Zustand, wobei beim Ausführen der Steuerung der Prozessor (CTRL) dazu eingerichtet ist, das Laden der parasitären Kapazität (PC) durch Versetzen eines der einen oder der mehreren Schalter (SW; SW1, ..., SWn), der zu dem negativen Eingangsanschluss (T2) korrespondiert, in den leitenden Zustand, und durch Herstellen eines elektrischen Durchgangs zwischen: der einen der zweiten Verdrahtungsleitungen (B; B1, ..., Bn), die mit dem negativen Eingangsanschluss (T2) gekoppelt ist; und dem Ausgangsanschluss (T3) durchzuführen.

3. Die Element-Array-Schaltung (1; 1B; 1C; 2; 3; 3A; 4) gemäß Anspruch 2, wobei der Prozessor (CTRL) dazu eingerichtet ist, nach dem Durchführen des Ladens der parasitären Kapazität (PC) den einen der einen oder mehreren Schalter (SW; SW1, ..., SWn), der zu dem negativen Eingangsanschluss (T2) korrespondiert, in den nichtleitenden Zustand zu schalten, und um nach dem Schalten des einen der einen oder mehreren Schalter (SW;

SW1, ..., SWn) eine von dem Ausgangsanschluss (T3) ausgegebene Ausgangsspannung (Vout) zu messen, wobei die Ausgangsspannung (Vout) aus einem der Impedanzelemente (R; R(1, 1), ..., R(m, n); SC; SC(1, 1), ..., SC(m, n)) resultiert, das sowohl mit der relevanten einen oder mehreren ersten Verdrahtungsleitungen (A; A1, ..., Am) als auch mit der einen der zweiten Verdrahtungsleitungen (B; B1, ..., Bn), die mit dem negativen Eingangsanschluss (T2) verbunden ist, verbunden ist.

4. Die Element-Array-Schaltung (3; 3A; 4) gemäß Anspruch 1, die ferner einen Selektor (SB) umfasst, der dazu eingerichtet ist, eine der zweiten Verdrahtungsleitungen (B; B1, ..., Bn) auszuwählen und die eine der ausgewählten zweiten Verdrahtungsleitungen (B; B1, ..., Bn) mit dem negativen Eingangsanschluss (T2) zu koppeln.

5. Die Element-Array-Schaltung (3; 3A; 4) gemäß Anspruch 4, die ferner einen Prozessor (CTRL) umfasst, der dazu eingerichtet ist, eine Steuerung auszuführen zum: Durchführen eines Ladens einer parasitären Kapazität (PC), die parasitär zu einer der zweiten Verdrahtungsleitungen (B; B1, ..., Bn) ist, die mit dem negativen Eingangsanschluss (T2) eines entsprechenden des einen oder der mehreren Operationsverstärker (OP; OP1, ..., OPn) gekoppelt ist; und Schalten, nach dem Durchführen des Ladens, eines der einen oder der mehreren Schalter (SW; SW1, ..., SWn), der zu dem negativen Eingangsanschluss (T2) korrespondiert, in den nichtleitenden Zustand, wobei

beim Ausführen der Steuerung der Prozessor (CTRL) dazu eingerichtet ist, das Laden der parasitären Kapazität (PC) durch Versetzen eines der einen oder der mehreren Schalter (SW; SW1, ..., SWn), der zu dem negativen Eingangsanschluss (T2) korrespondiert, in den leitenden Zustand und durch Herstellen eines elektrischen Durchgangs zwischen: der einen der zweiten Verdrahtungsleitungen (B; B1, ..., Bn), die mit dem negativen Eingangsanschluss (T2) gekoppelt ist; und dem Ausgangsanschluss (T3) durchzuführen, und
eine Zeitspanne, über die das Laden der parasitären Kapazität (PC) durchzuführen ist, indem der eine des einen oder der mehreren Schalter (SW; SW1, ..., SWn) in den leitfähigen Zustand versetzt wird, länger ist als das Fünffache eines Produkts aus einem Kapazitätswert der parasitären Kapazität (PC) und einer Summe eines Widerstandswerts des einen des einen oder der mehreren Schalter (SW; SW1, ..., SWn) und eines Widerstandswerts des Selektors (SB).

6. Die Element-Array-Schaltung (1; 1B; 1C; 2; 3; 3A; 4) gemäß Anspruch 1, wobei

der eine oder die mehreren Operationsverstärker (OP; OP1, ..., OPn) eine Mehrzahl der Operationsverstärker (OP; OP1, ..., OPn) umfassen,
der eine oder die mehreren Schalter (SW; SW1, ..., SWn) eine Mehrzahl der Schalter (SW; SW1, ..., SWn) umfassen,
die ein oder mehreren Umwandlungselemente (CP; CP1, ...., CPn; RE; RE1, ..., REn; D; D1, ..., Dn) eine Mehrzahl der Umwandlungselemente (CP; CP1, ...., CPn; RE; RE1, ..., REn; D; D1, ..., Dn) umfassen,
die Operationsverstärker (OP; OP1, ..., OPn) jeweils mit einer entsprechenden der zweiten Verdrahtungsleitungen (B; B1, ..., Bn) gekoppelt sind,
die Schalter (SW; SW1, ..., SWn) jeweils mit einem entsprechenden der Operationsverstärker (OP; OP1, ..., OPn) gekoppelt sind, und
die Umwandlungselemente (CP; CP1, ...., CPn; RE; RE1, ..., REn; D; D1, ..., Dn) jeweils mit einem entsprechenden der Operationsverstärker (OP; OP1, ..., OPn) gekoppelt sind.

7. Die Element-Array-Schaltung (1; 1B; 1C; 2; 3; 3A; 4) gemäß Anspruch 6, die ferner einen Prozessor (CTRL) umfasst, der dazu eingerichtet ist, eine Steuerung auszuführen zum: Durchführen eines Ladens einer parasitären Kapazität (PC), die parasitär zu einer der zweiten Verdrahtungsleitungen (B; B1, ..., Bn) ist, die mit dem negativen Eingangsanschluss (T2) eines entsprechenden der Operationsverstärker (OP; OP1, ..., OPn) gekoppelt ist; und Schalten, nach dem Durchführen des Ladens, eines der Schalter (SW; SW1, ..., SWn), der zu dem negativen Eingangsanschluss (T2) korrespondiert, in den nichtleitenden Zustand, wobei

beim Ausführen der Steuerung der Prozessor (CTRL) dazu eingerichtet ist, das Laden der parasitären Kapazität (PC) durch Versetzen des einen der Schalter (SW; SW1, ..., SWn), der zu dem negativen Eingangsanschluss (T2) korrespondiert, in den leitenden Zustand und durch Herstellen eines elektrischen Durchgangs zwischen: der einen der zweiten Verdrahtungsleitungen (B; B1, ..., Bn), die mit dem negativen Eingangsanschluss (T2) gekoppelt ist; und dem Ausgangsanschluss (T3) durchzuführen, und
eine Zeitspanne, über die das Laden der parasitären Kapazität (PC) durchzuführen ist, indem der eine der Schalter (SW; SW1, ..., SWn), der zu dem negativen Eingangsanschluss (T2) korrespondiert, in den leitfähigen Zustand versetzt wird, länger ist als das Fünffache eines Produkts aus einem Kapazitätswert der parasitären Kapazität (PC) und einem Widerstandswert des einen der Schalter (SW; SW1, ..., SWn).

8. Die Element-Array-Schaltung (1; 1B; 1C; 2; 3; 4) gemäß Anspruch 1, wobei

die eine oder mehreren ersten Verdrahtungsleitungen (A; A1, ..., An) eine Mehrzahl der ersten Verdrahtungsleitungen (A; A1, ..., An) umfassen, und
die Impedanzelemente (R; R(1, 1), ..., R(m, n); SC; SC(1, 1), ..., SC(m, n)) jeweils sowohl mit einer der ersten Verdrahtungsleitungen (A; A1, ..., An) als auch mit einer der zweiten Verdrahtungsleitungen (B; B1, ..., Bn) gekoppelt sind.

9. Die Element-Array-Schaltung (1; 1A; 1B; 3; 3A) gemäß Anspruch 2, wobei

die ein oder mehreren Umwandlungselemente (CP; CP1, ...., CPn; RE; RE1, ..., REn; D; D1, ..., Dn) einen oder mehrere Kondensatoren (CP; CP1, ..., CPn) umfassen, und
eine Zeitspanne, über die das Laden der parasitären Kapazität (PC) durchzuführen ist, indem der eine des einen oder der mehreren Schalter (SW; SW1, ..., SWn), der zu dem negativen Eingangsanschluss (T2) korrespondiert, in den leitfähigen Zustand versetzt wird, länger ist als das Fünffache eines Produkts aus einem Kapazitätswert von einem der einen oder mehreren Kondensatoren (CP; CP1, ..., CPn), der zu den negativen Eingangsanschluss (T2) korrespondiert, und eines Widerstandswerts des einen des einen oder der mehreren Schalter (SW; SW1, ..., SWn), der zu dem negativen Eingangsanschluss (T2) korrespondiert.

10. Die Element-Array-Schaltung (1; 1A; 1B; 1C; 2; 3; 3A; 4) gemäß Anspruch 1, wobei jedes der einen oder mehreren Umwandlungselemente (CP; CP1, ...., CPn; RE; RE1, ..., REn; D; D1, ..., Dn) einen Kondensator (CP), einen Widerstand (RE) oder ein Halbleiterelement (D) umfasst.

11. Die Element-Array-Schaltung (1; 1A; 1B; 1C; 2; 3; 3A; 4) gemäß Anspruch 1, wobei jedes der Impedanzelemente (R; R(1, 1), ..., R(m, n); SC; SC(1, 1), ..., SC(m, n)) einen Widerstand (R) oder ein Halbleiterelement (SC) umfasst.

12. Ein elektromagnetischer Wellensensor (101), der die Element-Array-Schaltung (1; 1B; 1C; 2; 3; 3A; 4) gemäß Anspruch 1 umfasst.

13. Ein Temperatursensor (101), der die Element-Array-Schaltung (1; 1B; 1C; 2; 3; 3A; 4) gemäß Anspruch 1 umfasst.

14. Ein Dehnungssensor (101), der die Element-Array-Schaltung (1; 1B; 1C; 2; 3; 3A; 4) gemäß Anspruch 1 umfasst.

**Revendications**

1. Circuit de réseau d'éléments (1 ; 1B ; 1C ; 2 ; 3 ; 3A ; 4) comprenant :

une ou plusieurs premières lignes de câblage (A ; A1, ..., Am) ;
une pluralité de secondes lignes de câblage (B ; B1, ..., Bn), les secondes lignes de câblage (B ; B1, ..., Bn) s'étendant chacune dans une direction différente d'une direction dans laquelle la ou les premières lignes de câblage (A ; A1, ..., Am) s'étendent chacune ;
une pluralité d'éléments d'impédance (R ; R(1, 1), ..., R(m, n) ; SC ; SC(1, 1), ..., SC(m, n)), les éléments d'impédance (R ; R(1, 1), ..., R(m, n) ; SC ; SC(1, 1), ..., SC(m, n)) étant couplés chacun à la fois à l'une de la ou des premières lignes de câblage (A ; A1, ..., Am) et à l'une des secondes lignes de câblage (B ; B1, ..., Bn) ;
un ou plusieurs amplificateurs opérationnels (OP ; OP1, ..., OPn) comportant chacun une borne d'entrée positive (T1), une borne d'entrée négative (T2), et une borne de sortie (T3), la borne d'entrée négative (T2) pouvant être couplée à l'une des secondes lignes de câblage (B ; B1, ..., Bn) ; et
un ou plusieurs éléments de conversion (CP ; CP1, ...., CPn ; RE ; RE1, ..., REn ; D ; D1, ..., Dn), chacun couplé à la borne d'entrée négative (T2) et à la borne de sortie (T3) de l'un correspondant du ou des amplificateurs opérationnels (OP ; OP1, ..., OPn), et chacun configuré pour convertir en une tension un courant circulant dans l'une des secondes lignes de câblage (B ; B1, ..., Bn) qui est couplée à la borne d'entrée négative (T2) ;
**caractérisé en ce que**
le circuit de réseau d'éléments (1 ; 1B ; 1C ; 2 ; 3 ; 3A ; 4) comprend en outre :
un ou plusieurs commutateurs (SW ; SW1 , ..., SWn), chacun couplé à l'un des éléments de conversion (CP ; CP1, ...., CPn ; RE ; RE1, ..., REn ; D ; D1, ..., Dn) en parallèle entre la borne d'entrée négative (T2) et la borne de sortie (T3) de l'un correspondant du ou des amplificateurs opérationnels (OP ; OP1, ..., OPn), et chacun configuré pour passer soit dans un état passant, soit dans un état non passant.

2. Circuit de réseau d'éléments (1 ; 1B ; 1C ; 2 ; 3 ; 3A ; 4) selon la revendication 1, comprenant en outre un processeur (CTRL) configuré pour exécuter une commande consistant à : réaliser la charge d'une capacité parasite (PC) parasitant l'une des secondes lignes de câblage (B ; B1, ..., Bn) qui est couplée à la borne d'entrée négative (T2) de l'un correspondant du ou des amplificateurs opérationnels (OP ; OP1, ..., OPn) ; et après avoir réalisé la charge, commuter à l'état non passant l'un du ou des commutateurs (SW ; SW1, ..., SWn) qui correspond à la borne d'entrée négative (T2), dans lequel

lors de l'exécution de la commande, le processeur (CTRL) est configuré pour réaliser la charge de la capacité parasite (PC) en amenant à l'état passant celui du ou des commutateurs (SW ; SW1, ..., SWn) qui correspond à la borne d'entrée négative (T2), et en établissant une continuité électrique entre : celle des secondes lignes de câblage (B ; B1, ..., Bn) qui est couplée à la borne d'entrée négative (T2) ; et la borne de sortie (T3).

3. Circuit de réseau d'éléments (1 ; 1B ; 1C ; 2 ; 3 ; 3A ; 4) selon la revendication 2, dans lequel le processeur (CTRL) est configuré, après avoir réalisé la charge de la capacité parasite (PC), commuter à l'état non passant celui du ou des commutateurs (SW ; SW1, ..., SWn) qui correspond à la borne d'entrée négative (T2), et après avoir commuté celui du ou des commutateurs (SW ; SW1, ..., SWn), pour mesurer une tension de sortie (Vout) issue de la borne de sortie (T3), la tension de sortie (Vout) résultant de l'un des éléments d'impédance (R ; R(1, 1), ..., R(m, n) ; SC ; SC(1, 1), ..., SC(m, n)) qui est couplé à la fois à celle de la ou des premières lignes de câblage (A ; A1, ..., Am) qui est concernée et à celle des secondes lignes de câblage (B ; B1, ..., Bn) qui est couplée à la borne d'entrée négative (T2).

4. Circuit de réseau d'éléments (3 ; 3A ; 4) selon la revendication 1, comprenant en outre un sélecteur (SB) configuré pour sélectionner l'une des secondes lignes de câblage (B ; B1, ..., Bn) et pour coupler celle des secondes lignes de câblage (B ; B1, ..., Bn) qui est sélectionnée à la borne d'entrée négative (T2).

5. Circuit de réseau d'éléments (3 ; 3A ; 4) selon la revendication 4, comprenant en outre un processeur (CTRL) configuré pour exécuter une commande consistant à : réaliser la charge d'une capacité parasite (PC) parasitant l'une des secondes lignes de câblage (B ; B1, ..., Bn) qui est couplée à la borne d'entrée négative (T2) de l'un correspondant du ou des amplificateurs opérationnels (OP ; OP1, ..., OPn) ; et après avoir réalisé la charge, commuter à l'état non passant l'un du ou des commutateurs (SW ; SW1, ..., SWn) qui correspond à la borne d'entrée négative (T2), dans lequel

lors de l'exécution de la commande, le processeur (CTRL) est configuré pour réaliser la charge de la capacité parasite (PC) en amenant à l'état passant celui du ou des commutateurs (SW ; SW1, ..., SWn) qui correspond à la borne d'entrée négative (T2), et en établissant une continuité électrique entre : celle des secondes lignes de câblage (B ; B1, ..., Bn) qui est couplée à la borne d'entrée négative (T2) ; et la borne de sortie (T3), et une période de temps, au cours de laquelle la charge de la capacité parasite (PC) doit être réalisée en amenant à l'état passant celui du ou des commutateurs (SW ; SW1, ..., SWn), est supérieure à cinq fois un produit d'une valeur de capacité de la capacité parasite (PC) par la somme d'une valeur de résistance dudit un du ou des commutateurs (SW ; SW1, ..., SWn) et une valeur de résistance du sélecteur (SB).

6. Circuit de réseau d'éléments (1 ; 1B ; 1C ; 2 ; 3 ; 3A ; 4) selon la revendication 1, dans lequel

le ou les amplificateurs opérationnels (OP ; OP1, ..., OPn) comprennent une pluralité des amplificateurs opérationnels (OP ; OP1, ..., OPn),
le ou les commutateurs (SW ; SW1, ..., SWn) comprennent une pluralité des commutateurs (SW ; SW1, ..., SWn),
le ou les éléments de conversion (CP ; CP1, ...., CPn ; RE, RE1, ..., REn ; D ; D1, ..., Dn) comprennent une pluralité des éléments de conversion (CP ; CP1, ...., CPn ; RE ; RE1, ..., REn ; D ; D1, ..., Dn),
les amplificateurs opérationnels (OP ; OP1, ..., OPn) sont couplés chacun à l'une correspondante des secondes lignes de câblage (B ; B1, ..., Bn),
les commutateurs (SW ; SW1, ..., SWn) sont couplés chacun à l'un correspondant des amplificateurs opérationnels (OP ; OP1, ..., OPn), et
les éléments de conversion (CP ; CP1, ..., CPn ; RE ; RE1, ..., REn ; D ; D1, ..., Dn) sont couplés chacun à l'un correspondant des amplificateurs opérationnels (OP ; OP1, ..., OPn).

7. Circuit de réseau d'éléments (1 ; 1B ; 1C ; 2 ; 3 ; 3A ; 4) selon la revendication 6, comprenant en outre un processeur (CTRL) configuré pour exécuter une commande consistant à réaliser la charge d'une capacité parasite (PC) parasitant l'une des secondes lignes de câblage (B ; B1, ..., Bn) qui est couplée à la borne d'entrée négative (T2) de l'un correspondant des amplificateurs opérationnels (OP ; OP1, ..., OPn) ; et après avoir réalisé la charge, commuter à l'état non passant l'un des commutateurs (SW ; SW1, ..., SWn) qui correspond à la borne d'entrée négative (T2), dans lequel

lors de l'exécution de la commande, le processeur (CTRL) est configuré pour réaliser la charge de la capacité parasite (PC) en amenant à l'état passant celui des commutateurs (SW ; SW1, ..., SWn) qui correspond à la borne d'entrée négative (T2), et en établissant une continuité électrique entre : celle des secondes lignes de câblage (B ; B1, ..., Bn) qui est couplée à la borne d'entrée négative (T2) ; et la borne de sortie (T3), et

une période de temps, au cours de laquelle la charge de la capacité parasite (PC) doit être réalisée en amenant à l'état passant celui des commutateurs (SW ; SW1, ..., SWn) qui correspond à la borne d'entrée négative (T2), est supérieure à cinq fois un produit d'une valeur de capacité de la capacité parasite (PC) par une valeur de résistance dudit un des commutateurs (SW ; SW1, ..., SWn).

8. Circuit de réseau d'éléments (1 ; 1B ; 1C ; 2 ; 3 ; 4) selon la revendication 1, dans lequel

la ou les premières lignes de câblage (A ; A1, ..., An) comprennent une pluralité des premières lignes de câblage (A ; A1, ..., An), et

les éléments d'impédance (R ; R(1, 1), ..., R(m, n) ; SC ; SC(1, 1), ..., SC(m, n)) sont couplés chacun à la fois à l'une des premières lignes de câblage (A ; A1, ..., An) et à l'une des secondes lignes de câblage (B ; B1, ..., Bn).

9. Circuit de réseau d'éléments (1 ; 1A ; 1B ; 3 ; 3A) selon la revendication 2, dans lequel

le ou les éléments de conversion (CP ; CP1, ...., CPn ; RE, RE1, ..., REn ; D ; D1, ..., Dn) comprennent un ou plusieurs condensateurs (CP ; CP1, ..., CPn), et

une période de temps, au cours de laquelle la charge de la capacité parasite (PC) doit être réalisée en amenant à l'état passant celui du ou des commutateurs (SW ; SW1, ..., SWn) qui correspond à la borne d'entrée négative (T2), est supérieure à cinq fois un produit d'une valeur de capacité de l'un du ou des condensateurs (CP ; CP1, ..., CPn) qui correspond à la borne d'entrée négative (T2) par une valeur de résistance de celui du ou des commutateurs (SW ; SW1, ..., SWn) qui correspond à la borne d'entrée négative (T2).

10. Circuit de réseau d'éléments (1 ; 1A ; 1B ; 1C ; 2 ; 3 ; 3A ; 4) selon la revendication 1, dans lequel chacun du ou des éléments de conversion (CP ; CP1, ...., CPn ; RE ; RE1, ..., REn ; D ; D1, ..., Dn) comprend un condensateur (CP), une résistance (RE) ou un élément semi-conducteur (D).

11. Circuit de réseau d'éléments (1 ; 1A ; 1B ; 1C ; 2 ; 3 ; 3A ; 4) selon la revendication 1, dans lequel chacun des éléments d'impédance (R ; R(1, 1), ..., R(m, n), SC ; SC(1, 1), ..., SC(m, n)) comprend une résistance (R) ou un élément semi-conducteur (SC).

12. Capteur d'ondes électromagnétiques (101) comprenant un circuit de réseau d'éléments (1 ; 1B ; 1C ; 2 ; 3 ; 3A ; 4) selon la revendication 1.

13. Capteur de température (101) comprenant un circuit de réseau d'éléments (1 ; 1B ; 1C ; 2 ; 3 ; 3A ; 4) selon la revendication 1.

14. Capteur de contrainte (101) comprenant un circuit de réseau d'éléments (1 ; 1B ; 1C ; 2 ; 3 ; 3A ; 4) selon la revendication 1.

FIG. 1

24

```
                    ┌─────────────┐
                    (    START    )
                    └─────────────┘
                           │
                           │                        S101
     ┌─────────────────────────────────────────────────┐
     │           CAUSE ALL SWITCHES TO BE               │
     │           IN NONCONDUCTING STATE                 │
     └─────────────────────────────────────────────────┘
                           │
                           │                        S102
     ┌─────────────────────────────────────────────────┐
     │   SELECT ROW LINE CORRESPONDING TO SELECTED      │
     │   RESISTOR RS TO BE SELECTED ROW LINE AS         │
     └─────────────────────────────────────────────────┘
                           │
                           │                        S103
     ┌─────────────────────────────────────────────────┐
     │ CAUSE SWITCHES SW CORRESPONDING TO RESPECTIVE    │
     │ COLUMN LINES B TO BE IN CONDUCTING STATE         │
     └─────────────────────────────────────────────────┘
                           │
                           │                        S104
     ┌─────────────────────────────────────────────────┐
     │ CAUSE SWITCHES SW CORRESPONDING TO RESPECTIVE    │
     │ COLUMN LINES B TO BE IN NONCONDUCTING STATE      │
     └─────────────────────────────────────────────────┘
                           │
                           │                        S105
     ┌─────────────────────────────────────────────────┐
     │ MEASURE OUTPUT VOLTAGE Vout CORRESPONDING        │
     │ TO SELECTED RESISTOR RS                          │
     └─────────────────────────────────────────────────┘
                           │
                    ┌─────────────┐
                    (     END     )
                    └─────────────┘
```

FIG. 2

FIG. 3

FIG. 4

FIG. 5

FIG. 6

```
                    ┌─────────────┐
                    │    START    │
                    └──────┬──────┘
                           │
                           │                    S301
        ┌──────────────────┴──────────────────┐
        │        CAUSE ALL SWITCHES TO BE      │
        │         IN NONCONDUCTING STATE       │
        └──────────────────┬──────────────────┘
                           │
                           │                    S302
        ┌──────────────────┴──────────────────┐
        │  SELECT ROW LINE CORRESPONDING TO    │
        │  SELECTED RESISTOR RS TO BE SELECTED │
        │          ROW LINE AS                 │
        └──────────────────┬──────────────────┘
                           │
                           │                    S303
        ┌──────────────────┴──────────────────┐
        │ SELECT COLUMN LINE CORRESPONDING TO  │
        │ SELECTED RESISTOR RS TO BE SELECTED  │
        │        COLUMN LINE BS                │
        └──────────────────┬──────────────────┘
                           │
                           │                    S304
        ┌──────────────────┴──────────────────┐
        │ CAUSE SWITCH SW TO BE IN CONDUCTING  │
        │              STATE                   │
        └──────────────────┬──────────────────┘
                           │
                           │                    S305
        ┌──────────────────┴──────────────────┐
        │ CAUSE SWITCH SW TO BE IN NON-        │
        │        CONDUCTING STATE              │
        └──────────────────┬──────────────────┘
                           │
                           │                    S306
        ┌──────────────────┴──────────────────┐
        │ MEASURE OUTPUT VOLTAGE Vout          │
        │ CORRESPONDING TO SELECTED RESISTOR RS│
        └──────────────────┬──────────────────┘
                           │
                    ┌──────┴──────┐
                    │     END     │
                    └─────────────┘
```

FIG. 7

EP 4 312 029 B1

FIG. 8

31

FIG. 9

101

DETECTOR

OUTPUTTER — 40

ARITHMETIC PROCESSOR — 20

STORAGE — 30

10

FIG. 10

FIG. 11

FIG. 12

FIG. 13

FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H0894443 A

**Non-patent literature cited in the description**

- New Approaches for Increasing Accuracy in Readout of Resistive Sensor Arrays. **HIDALGO-LOPEZ JOSE**. IEEE SENSORS JOURNAL. IEEE, 01 April 2017, vol. 17, 2154-2164